# EUROPEAN PATENT APPLICATION

(11) **EP 4 572 583 A1**
(43) Date of publication of application: **18.06.2025**
(21) Application number: 24214357.6
(22) Date of filing: 20.11.2024
(51) Int. Cl.: H10K 59/80, H10K 71/00

(54) **DISPLAY DEVICE AND METHOD FOR MANUFACTURING THE DISPLAY DEVICE**

(30) Priority: 12.12.2023 KR 20230179498
(71) Applicant: Samsung Display Co., Ltd., Yongin-si, Gyeonggi-do 17113 (KR)
(72) Inventor: YOON, Hee Chang, Yongin-si (KR); KWON, Seung Wook, Yongin-si (KR); KIM, Sun Hwa, Yongin-si (KR); MUN, Hyo Young, Yongin-si (KR); AHN, Sang Tae, Yongin-si (KR); UM, Yi Seul, Yongin-si (KR); LEE, Kwan Hee, Yongin-si (KR); CHAE, Seung Yeon, Yongin-si (KR)
(74) Representative: Marks & Clerk LLP

(57) **Abstract**

A display device and method for manufacturing the display device are provided. The display device includes a display panel including at least one conductive layer (TFTL) and at least one non-conductive film (ENC) on the at least one conductive layer (TFTL); a first residue trace (RSD1) on a top surface of the at least one non-conductive film (ENC); and a second residue trace (RSD2) on one side of the first residue trace (RSD1).

## Description

### BACKGROUND

### 1. Field

The present disclosure relates to a display device and a method for manufacturing the display device.

### 2. Description of the Related Art

With the advance of information-oriented society, more and more demands are placed on display devices for displaying images in various ways. The display device may be a flat panel display device such as a liquid crystal display, a field emission display and a light emitting display.

The display device includes a display area for displaying an image and a non-display area disposed around the display area, for example, to surround the display area. Recently, the width of the non-display area has been gradually reduced to increase immersion in the display area and enhance the aesthetics of the display device.

In the manufacturing process of the display device, the display device may be formed by cutting a mother substrate along a plurality of display cells formed on the mother substrate including the plurality of display cells.

The non-display area may include a first non-display area in which lines and circuits for driving the display area are disposed, and a second non-display area corresponding to a margin for a cutting process in a manufacturing process of a display device. Because there is a limit to reducing lines and circuits in the first non-display area, a method of reducing the width of the second non-display area is being researched.

### SUMMARY

Aspects of the present disclosure provide a display device that reduces or minimizes a width of a non-display area and a method for manufacturing the display device.

Aspects of the present disclosure also provide a display device with improved process efficiency and process yield, and a method for manufacturing the display device.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

In one or more embodiments, a display device includes a display panel including at least one conductive layer and at least one non-conductive film on the at least one conductive layer; a first residue trace on a top surface of the at least one non-conductive film; and a second residue trace on one side of the first residue trace.

In one or more embodiments, the first residue trace may be on a top surface of the display panel; and the second residue trace may be on a side surface or the top surface of the display panel.

In one or more embodiments, the second residue trace may be adjacent to an edge of the display panel; and the first residue trace may be surrounded by the second residue trace.

In one or more embodiments, the display panel may include a through hole penetrating the display panel and located in a display area of the display panel; and the first residue trace may include an opening surrounding the through hole.

In one or more embodiments, the second residue trace may be in the opening, and may surround the through hole.

In one or more embodiments, the opening may be larger than the through hole in a plan view; and the second residue trace may be between the opening and the through hole.

In one or more embodiments, the display panel may have a display area and a non-display area on one side of the display area; and at least a part of the first residue trace may be in the display area, and at least a part of the second residue trace may be in the non-display area.

In one or more embodiments, a light transmittance of the first residue trace may be higher than a light transmittance of the second residue trace.

In one or more embodiments, material compositions contained respectively in the first residue trace and the second residue trace may be different from each other.

In one or more embodiments, the first residue trace may include at least one of acrylic resin, epoxy resin, or urethane resin; and the second residue trace may include at least one of acrylic resin, polyethylene resin, polyvinyl chloride resin, thiol resin, epoxy resin, or silicone resin.

In one or more embodiments, each of the first residue trace and the second residue trace may include a same material as the at least one non-conductive film below the first residue trace and the second residue trace.

In one or more embodiments, the second residue trace may have higher acid resistance than that of the first residue trace.

In one or more embodiments, the second residue trace may include a fluoropolymer.

In one or more embodiments, the second residue trace may include at least one of polytetrafluoroethylene (PTFE) or polyvinylidene fluoride.

In one or more embodiments, the display panel may include: a substrate; a light emitting element layer on the substrate; and an encapsulation layer on the light emitting element layer, the first residue trace being on the encapsulation layer, and the second residue trace being on the encapsulation layer and the substrate.

In one or more embodiments, the encapsulation layer may expose at least a part of a top surface of the substrate at an edge of the display panel, and the second residue trace may be on the exposed top surface of the substrate.

In one or more embodiments, a method for manufacturing a display device includes: forming a plurality of display cells on a mother substrate; forming a coating layer on each of the plurality of display cells; forming an acid resistant layer between the plurality of display cells; forming a plurality of first laser irradiation areas by irradiating first laser to the mother substrate; attaching a protective film onto the mother substrate; and cutting the mother substrate along the plurality of first laser irradiation areas by spraying an etchant on the mother substrate without a mask.

In one or more embodiments, the coating layer may be formed by an inkjet printing process; and the acid resistant layer may be formed by one of inkjet printing, dispenser printing, screen printing, or slit coating.

In one or more embodiments, material compositions in the coating layer and the acid resistant layer may be different from each other.

In one or more embodiments, the coating layer may comprise at least one of acrylic resin, epoxy resin, or urethane resin, and a residue trace may comprise at least one of acrylic resin, polyethylene resin, polyvinyl chloride resin, thiol resin, epoxy resin, or silicone resin.

In one or more embodiments, the acid resistant layer may have higher acid resistance than that of the coating layer.

In one or more embodiments, the acid resistant layer may comprise a fluoropolymer.

In one or more embodiments, the acid resistant layer may comprise at least one of polytetrafluoroethylene (PTFE) or polyvinylidene fluoride.

In one or more embodiments, the method may further include forming a plurality of second laser irradiation areas by irradiating second laser to the mother substrate, wherein in the cutting of the mother substrate along the plurality of first laser irradiation areas, a through hole penetrating the plurality of display cells is formed along the plurality of second laser irradiation areas.

In one or more embodiments, the coating layer may comprise an opening around the through hole, the acid resistant layer may be in the opening, and the acid resistant layer may fill the opening.

At least some of the above and other features of the invention are set out in the claims.

According to the display device and the method for manufacturing the display device according to one embodiment of the present disclosure, the width of the non-display area may be minimized.

In the display device and the method for manufacturing the display device according to one or more embodiments of the present disclosure, process efficiency and process yield may be improved.

However, effects according to the present disclosure are not limited to those exemplified above and various other effects are incorporated herein.

### BRIEF DESCRIPTION OF THE DRAWINGS

The above and other aspects and features of the present disclosure will become more apparent by describing in detail embodiments thereof with reference to the attached drawings, in which:
FIG. 1 is a perspective view showing a display device according to one or more embodiments;
FIG. 2 is a plan view illustrating a display panel and a driving IC according to one or more embodiments;
FIG. 3 is a cross-sectional view taken along the line X1-X1' of FIG. 1;
FIG. 4 is a cross-sectional view showing the display device of FIG. 3 in a bent state;
FIG. 5 is a cross-sectional view illustrating an example of a display area of a display device according to one or more embodiments;
FIG. 6 is an enlarged view of an area A of FIG. 2;
FIG. 7 is a cross-sectional view taken along the line X2-X2' of FIG. 6;
FIG. 8 is an enlarged view of an area C of FIG. 7;
FIG. 9 is an enlarged view of an area B of FIG. 2;
FIG. 10 is a cross-sectional view taken along the line X3-X3' of FIG. 9;
FIG. 11 is an enlarged view of an area D of FIG. 10;
FIG. 12A is a plan view illustrating a residue trace of a display device according to one or more embodiments;
FIG. 12B shows photographs illustrating a process through which a residue trace of a display device according to one or more embodiments is formed;
FIG. 13 is a flowchart showing a method for manufacturing a display device according to one or more embodiments;
FIG. 14 is an diagram illustrating the depth of a laser irradiation area formed by a laser processing device according to one or more embodiments;
FIG. 15 is a perspective view showing S110 of FIG. 13;
FIG. 16 is a perspective view showing S120 of FIG. 13;
FIG. 17 is a perspective view showing S130 of FIG. 13;
FIG. 18 is a perspective view showing S140 of FIG. 13;
FIG. 19 is a perspective view showing S150 of FIG. 13;
FIG. 20 is a perspective view showing S170 of FIG. 13;
FIG. 21 is a plan view showing S170 of FIG. 13;
FIG. 22 is a perspective view showing S180 of FIG. 13;
FIG. 23 is a cross-sectional view showing S120 of FIG. 13;
FIG. 24 shows a photograph illustrating a cross-sectional view showing a coating layer according to one or more embodiments;
FIG. 25 is a cross-sectional view showing S130 of FIG. 13;
FIG. 26 is a cross-sectional view showing S140 of FIG. 13;
FIGS. 27 and 28 are cross-sectional views showing S160 and S170 of FIG. 13;
FIG. 29 is a cross-sectional view showing S180 of FIG. 13;
FIG. 30 is a cross-sectional view showing S120 of FIG. 13;
FIG. 31 is a cross-sectional view showing S130 of FIG. 13;
FIG. 32 is a cross-sectional view showing S150 of FIG. 13;
FIGS. 33 and 34 are cross-sectional views showing S160 and S170 of FIG. 13;
FIG. 35 is a cross-sectional view showing S180 of FIG. 13;
FIG. 36 is a photograph showing a through hole and the vicinity thereof according to a conventional embodiment;
FIG. 37 is a photograph showing a through hole and the vicinity thereof according to one or more embodiments;
FIGS. 38 and 39 are cross-sectional views showing S180_1 according to one or more embodiments;
FIG. 40 is a cross-sectional view showing S180_2 according to one or more embodiments;
FIGS. 41 and 42 are cross-sectional views showing S180_3 according to one or more embodiments;
FIGS. 43 and 44 are cross-sectional views showing S180_4 according to one or more embodiments; and
FIGS. 45 to 47 are cross-sectional views showing S180_5 according to one or more embodiments.

### DETAILED DESCRIPTION

The present disclosure will now be described more fully hereinafter with reference to the accompanying drawings, in which embodiments of the present disclosure are shown. The present disclosure may, however, be embodied in different forms and should not be construed as limited to the embodiments set forth herein. Rather, these embodiments are provided so that the present disclosure will be thorough and complete, and will fully convey the scope of the present disclosure to those skilled in the art.

It will also be understood that when a layer is referred to as being "on" another layer or substrate, it can be directly on the other layer or substrate, or intervening layers may also be present. The same reference numbers indicate the same components throughout the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

Hereinafter, embodiments of the present disclosure will be described in detail with reference to the accompanying drawings.

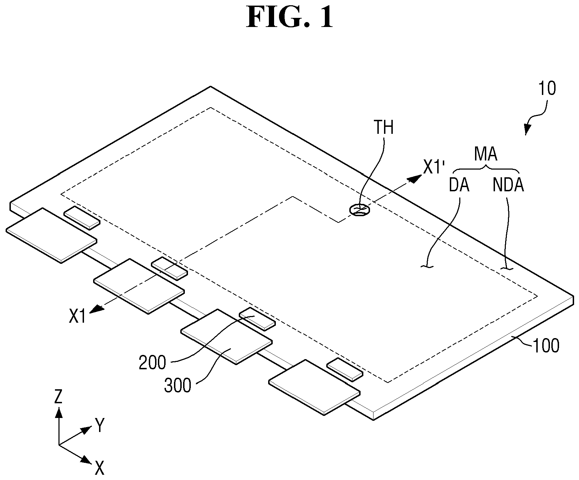

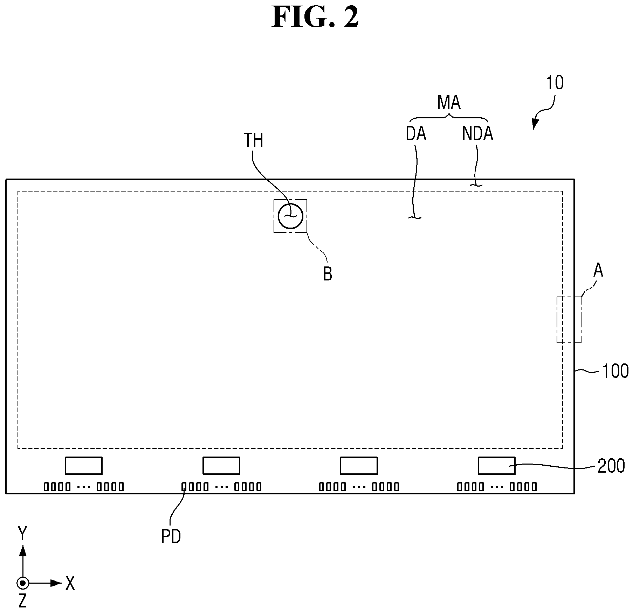

FIG. 1 is a perspective view showing a display device according to one or more embodiments. FIG. 2 is a plan view illustrating a display panel and a driving IC according to one or more embodiments.

Referring to FIGS. 1 and 2, a display device 10 is a device for displaying a moving image and/or a still image. The display device 10 may be used as a display screen of various devices, such as a television, a laptop computer, a monitor, a billboard and an Internet-of-Things (IOT) device, as well as portable electronic devices such as a mobile phone, a smartphone, a tablet personal computer (PC), a smart watch, a watch phone, a mobile communication terminal, an electronic notebook, an electronic book, a portable multimedia player (PMP), a navigation device, and/or an ultra-mobile PC (UMPC).

The display device 10 according to one or more embodiments may be a light emitting display device such as an organic light emitting display using an organic light emitting diode (OLED), a quantum dot light emitting display including a quantum dot light emitting layer, an inorganic light emitting display including an inorganic semiconductor, and a micro or nano light emitting display using a micro or nano light emitting diode (LED). In the following description, it is assumed that the display device 10 is an organic light emitting display device, but the present disclosure is not limited thereto.

The display device 10 according to one or more embodiments may include a display panel 100, a driving integrated circuit (IC) 200, and a circuit board 300.

The display panel 100 may be formed in a rectangular shape, in a plan view, having long sides in a first direction (X-axis direction) and short sides in a second direction (Y-axis direction) crossing the first direction (X-axis direction). A corner formed by the long side in the first direction (X-axis direction) and the short side in the second direction (Y-axis direction) may be right-angled or rounded with a curvature. The planar shape of the display panel 100 is not limited to the rectangular shape, and may be formed in another polygonal shape, a circular shape, or an elliptical shape.

In the illustrated figure, the first direction (X-axis direction) and the second direction (Y-axis direction) cross each other as horizontal directions. For example, the first direction (X-axis direction) and the second direction (Y-axis direction) may be orthogonal to each other. In addition, the third direction (Z-axis direction) crosses the first direction (X-axis direction) and the second direction (Y-axis direction), and may be, for example, perpendicular directions orthogonal to each other. In the present disclosure, directions indicated by arrows of the first to third directions DR1, DR2, and DR3 (X-axis direction, Y-axis direction, and Z-axis direction) may be referred to as one side, and the opposite directions thereto may be referred to as the other side.

The display panel 100 may be formed to be flat, but is not limited thereto. For example, the display panel 100 may include a curved portion formed at left and right ends and having a constant curvature or a varying curvature. In addition, the display panel 100 may be formed flexibly so that it can be curved, bent, folded, and/or rolled.

The display panel 100 may include a display area DA displaying an image and a non-display area NDA disposed around the display area DA along an edge or a periphery of the display area DA. The display area DA and the non-display area NDA may constitute a main region MA.

The display area DA may occupy most of the area of the display panel 100. The display area DA may be disposed at the center of the display panel 100. Pixels each including a plurality of emission areas may be disposed in the display area DA to display an image.

The non-display area NDA may be disposed adjacent to the display area DA. The non-display area NDA may be an area outside the display area DA. The non-display area NDA may be disposed to be around (e.g., to surround) the display area DA. The non-display area NDA may be an edge area of the display panel 100.

Display pads PD may be arranged in the non-display area NDA to be connected to the circuit boards 300. The display pads PD may be disposed on one side edge of the display panel 100. For example, the display pads PD may be disposed at the lower edge of the display panel 100.

The driving ICs 200 may generate the data voltages, the source voltages, the scan timing signals, and/or the like. The driving ICs 200 may output the data voltages, the source voltages, the scan timing signals, and/or the like.

The driving ICs 200 may be disposed between the display pads PD and the display area DA in the non-display area NDA. Each of the driving ICs 200 may be attached to the non-display area NDA of the display panel 100 in a chip-on-glass (COG) method. Alternatively, each of the driving ICs 200 may be attached to the circuit board 300 in a chip-on-plastic (COP) method.

The circuit boards 300 may be disposed on the display pads PD disposed on one side edge of the display panel 100. The circuit boards 300 may be attached to the display pads PD by using a conductive adhesive member such as an anisotropic conductive film and an anisotropic conductive adhesive. Accordingly, the circuit boards 300 may be electrically connected to the signal lines of the display panel 100. The circuit boards 300 may be a flexible printed circuit board (FPCB) and/or a flexible film such as a chip-on-film (COF).

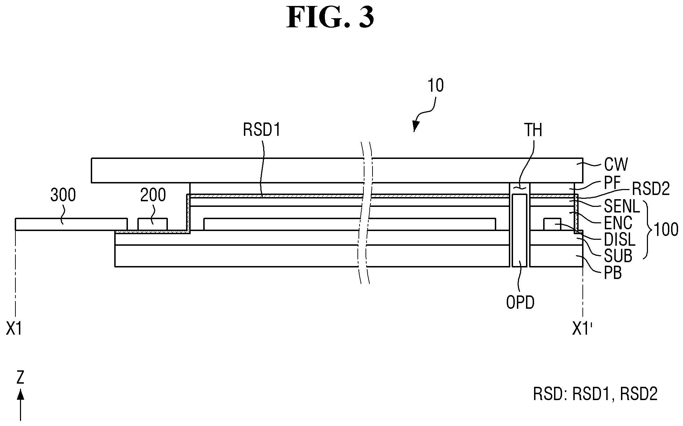

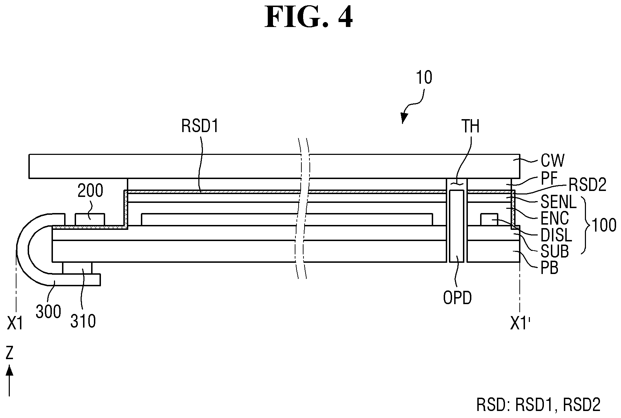

FIG. 3 is a cross-sectional view taken along the line X1-X1' of FIG. 1. FIG. 4 is a cross-sectional view showing the display device of FIG. 3 in a bent state.

Referring to FIGS. 3 and 4 in addition to FIGS. 1 and 2, the display device 10 according to one or more embodiments may include the display panel 100, a polarizing film PF, a cover window CW, a panel lower cover PB, the driving IC 200, and the circuit board 300. The display panel 100 may include a substrate SUB, a display layer DISL, an encapsulation layer ENC, and a sensor electrode layer SENL.

The substrate SUB may have a hard material. For example, the substrate SUB may be made of glass. The substrate SUB may be formed of ultra-thin glass (UTG) having a thickness of approximately 500 µm or less. In one or more embodiments, the thickness of the substrate SUB may be approximately 200 µm. In one or more embodiments, the substrate SUB may include a first substrate made of a hard material and a second substrate made of polymer resin made of a flexible material.

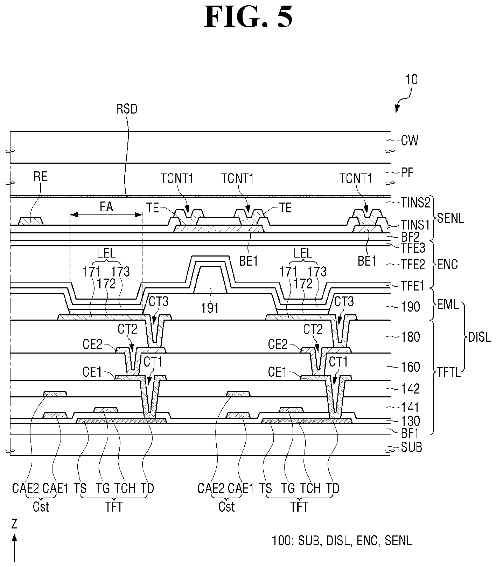

The display layer DISL may be disposed on the first surface of the substrate SUB. The display layer DISL may be a layer displaying an image. The display layer DISL may include a thin film transistor layer TFTL (see FIG. 5) in which thin film transistors are formed, and a light emitting element layer EML (see FIG. 5) in which light emitting elements emitting light are disposed in the emission areas.

In the display area DA of the display layer DISL, scan lines, data lines, power lines, and/or the like for the emission areas to emit light may be disposed. In the non-display area NDA of the display layer DISL, a scan driving circuit unit outputting scan signals to the scan lines, fan-out lines connecting the data lines and the driving IC 200, and/or the like may be disposed.

The encapsulation layer ENC may be a layer for encapsulating the light emitting element layer of the display layer DISL to prevent permeation of oxygen or moisture into the light emitting element layer of the display layer DISL. The encapsulation layer ENC may be disposed on the display layer DISL. The encapsulation layer ENC may be disposed on the top surfaces and the side surfaces of the display layer DISL. The encapsulation layer ENC may be disposed to cover the display layer DISL.

The sensor electrode layer SENL may be disposed on the display layer DISL. The sensor electrode layer SENL may include sensor electrodes. The sensor electrode layer SENL may sense a user's touch using sensor electrodes.

The polarizing film PF may be disposed on the sensor electrode layer SENL. The polarizing film PF may be disposed on the display panel 100 to reduce reflection of external light. The polarizing film PF may include a first base member, a linear polarization plate, a phase retardation film such as a quarter-wave plate (λ/4 plate), and a second base member. The first base member, the phase retardation film, the linear polarization plate, and the second base member of the polarizing film PF may be sequentially stacked on the display panel 100.

The cover window CW may be disposed on the polarizing film PF. The cover window CW may be attached onto the polarizing film PF by a transparent adhesive member such as an optically clear adhesive (OCA) film.

The panel lower cover PB may be disposed on a second surface of the substrate SUB of the display panel 100. The second surface of the substrate SUB may be a surface opposite to the first surface. The panel lower cover PB may be attached to the second surface of the substrate SUB of the display panel 100 through an adhesive member. The adhesive member may be a pressure sensitive adhesive (PSA).

The panel lower cover PB may include at least one of a light blocking member for absorbing light incident from the outside, a buffer member for absorbing an impact from the outside, or a heat dissipation member for efficiently dissipating heat from the display panel 100.

In one or more embodiments, the driving IC 200 and the circuit board 300 may be bent downward of the display panel 100 as illustrated in FIG. 4. The circuit board 300 may be attached to the bottom surface of the panel lower cover PB by an adhesive member 310. The adhesive member 310 may be a pressure sensitive adhesive.

The display device 10 may further include a through hole TH and an optical device OPD disposed in the through hole TH.

The through hole TH may be a hole capable of transmitting light, and may be a physical hole penetrating not only the display panel 100 but also the panel lower cover PB and the polarizing film PF. For example, the through hole TH may penetrate the substrate SUB, the display layer DISL, the encapsulation layer ENC, and the sensor electrode layer SENL of the display panel 100. However, the present disclosure is not limited thereto, and the through hole TH may penetrate the panel lower cover PB but may not penetrate the display panel 100 and the polarizing film PF. The cover window CW may be disposed to cover the through hole TH.

The optical device OPD may be spaced (e.g., spaced apart) from the display panel 100, the panel lower cover PB, and the polarizing film PF. The optical device OPD may be an optical sensor that senses light incident through the through hole TH, such as a proximity sensor, an illuminance sensor, and/or a camera sensor.

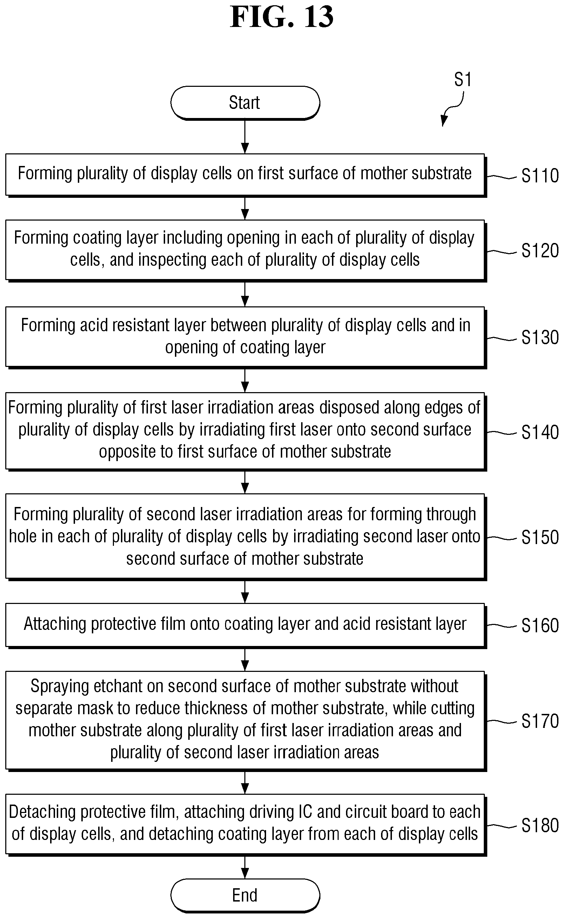

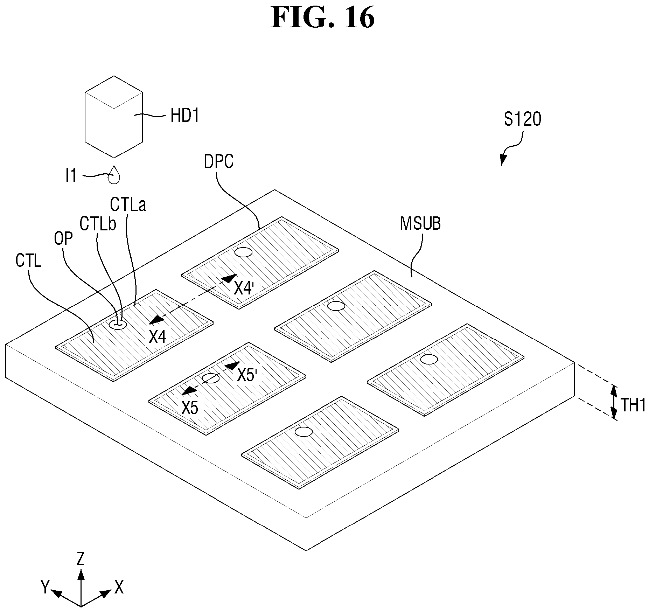

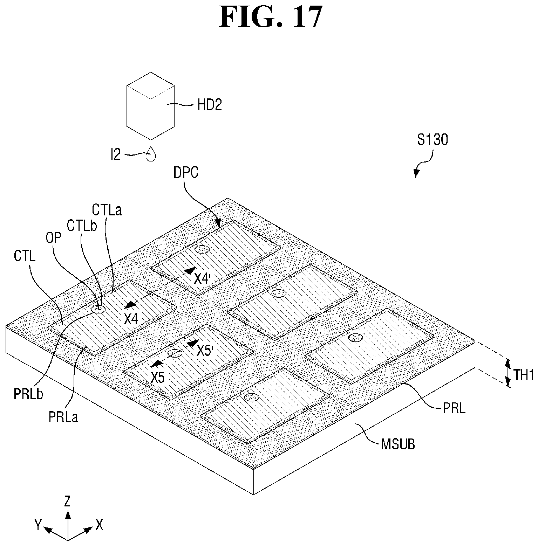

The display device 10 according to the present embodiment may include a residue trace RSD disposed on the display panel 100. For example, the residue trace RSD may be disposed between the display panel 100 and the polarizing film PF and on the side surface of the display panel 100. The residue trace RSD may be a removal trace formed by removing a coating layer CTL (see FIG. 16) and an acid resistant layer PRL (see FIG. 17) in a manufacturing method S1 (see FIG. 13) for a display device to be described later.

The residue trace RSD may include a first residue trace RSD1 and a second residue trace RSD2. The first residue trace RSD1 may be a removal trace that is formed when the coating layer CTL (see FIG. 16) is removed in the manufacturing method S1 (see FIG. 13) for a display device to be described later. The second residue trace RSD2 may be a removal trace formed by removing the acid resistant layer PRL (see FIG. 17) in the manufacturing method S1 (see FIG. 13) for a display device to be described later.

In one or more embodiments, as illustrated in the drawings, the residue trace RSD may be disposed on the sensor electrode layer SENL. However, the present disclosure is not limited thereto, and when the sensor electrode layer SENL is omitted, the residue trace RSD may be disposed on the encapsulation layer ENC.

FIG. 5 is a cross-sectional view illustrating an example of a display area of a display device according to one or more embodiments.

Referring to FIG. 5, the display device 10 according to one or more embodiments may include the display panel 100, the polarizing film PF, and the cover window CW.

In one or more embodiments, the display panel 100 may be an organic light emitting display panel having a light emitting element LEL including an organic light emitting layer 172. The display panel 100 may include the substrate SUB, the display layer DISL, the encapsulation layer ENC, and the sensor electrode layer SENL. The display layer DISL may include the thin film transistor layer TFTL including a plurality of thin film transistors and the light emitting element layer EML including a plurality of light emitting elements.

The substrate SUB may have a hard material. For example, the substrate SUB may be made of glass. The substrate SUB may be formed of ultra-thin glass (UTG) having a thickness of approximately 500 µm or less. In one or more embodiments, the thickness of the substrate SUB may be approximately 200 µm. In one or more other embodiments, the substrate SUB may include a first substrate made of a hard material and a second substrate made of polymer resin made of a flexible material.

The display layer DISL may include the thin film transistor layer TFTL including a plurality of thin film transistors (TFTs) and the light emitting element layer EML including a plurality of light emitting elements LEL.

The thin film transistor layer TFTL may include a first buffer layer BF1, a thin film transistor TFT, a gate insulating layer 130, a first interlayer insulating layer 141, a capacitor Cst, a second interlayer insulating layer 142, a first data metal layer, a first organic layer 160, a second data metal layer, and a second organic layer 180.

The first buffer layer BF1 may be disposed on the substrate SUB. The first buffer layer BF1 may be formed of an inorganic material such as a silicon nitride layer, a silicon oxynitride layer, a silicon oxide layer, a titanium oxide layer, and/or an aluminium oxide layer. Alternatively, the first buffer layer BF1 may be formed as a multilayer in which a plurality of layers selected from a silicon nitride layer, a silicon oxynitride layer, a silicon oxide layer, a titanium oxide layer, and/or an aluminium oxide layer are alternately stacked.

An active layer including a channel region TCH, a source region TS, and a drain region TD of the thin film transistor TFT may be disposed on the first buffer layer BF1. The active layer may be formed of polycrystalline silicon, monocrystalline silicon, low-temperature polycrystalline silicon, amorphous silicon, and/or an oxide semiconductor material. When the active layer includes polycrystalline silicon and/or an oxide semiconductor material, the source region TS and the drain region TD of the active layer may be conductive regions doped with ions or impurities and having conductivity.

The gate insulating layer 130 may be disposed on the active layer of the thin film transistor TFT and the buffer layer BF1. The gate insulating layer 130 may be formed of an inorganic layer, for example, a silicon nitride layer, a silicon oxynitride layer, a silicon oxide layer, a titanium oxide layer, and/or an aluminium oxide layer.

A first gate metal layer including a gate electrode TG of the thin film transistor TFT, a first capacitor electrode CAE1 of the capacitor Cst, and scan lines may be disposed on the gate insulating layer 130. The gate electrode TG of the thin film transistor TFT may overlap the channel region TCH in the third direction (Z-axis direction). The first gate metal layer may be formed as a single layer or multiple layers made of molybdenum (Mo), aluminium (Al), chromium (Cr), gold (Au), titanium (Ti), nickel (Ni), neodymium (Nd), and/or copper (Cu), and/or an alloy thereof.

The first interlayer insulating layer 141 may be disposed on the first gate metal layer and the gate insulating layer 130. The first interlayer insulating layer 141 may be formed of an inorganic layer, for example, a silicon nitride layer, a silicon oxynitride layer, a silicon oxide layer, a titanium oxide layer, and/or an aluminium oxide layer. The first interlayer insulating layer 141 may include a plurality of inorganic layers.

A second gate metal layer including a second capacitor electrode CAE2 of the capacitor Cst may be disposed on the first interlayer insulating layer 141. The second capacitor electrode CAE2 may overlap the first capacitor electrode CAE1 in the third direction (Z-axis direction). Therefore, the capacitor Cst may be formed by the first capacitor electrode CAE1, the second capacitor electrode CAE2, and an inorganic insulating dielectric layer (e.g., the first interlayer insulating layer 141) disposed therebetween to serve as a dielectric layer. The second gate metal layer may be formed as a single layer or multiple layers made of molybdenum (Mo), aluminium (Al), chromium (Cr), gold (Au), titanium (Ti), nickel (Ni), neodymium (Nd), and/or copper (Cu), and/or an alloy thereof.

The second interlayer insulating layer 142 may be disposed on the second gate metal layer and the first interlayer insulating layer 141. The second interlayer insulating layer 142 may be formed of an inorganic layer, for example, a silicon nitride layer, a silicon oxynitride layer, a silicon oxide layer, a titanium oxide layer, and/or an aluminium oxide layer. The second interlayer insulating layer 142 may include a plurality of inorganic layers.

The first data metal layer including a first connection electrode CE1 and the data lines may be disposed on the second interlayer insulating layer 142. The first connection electrode CE1 may be connected to the drain region TD of the thin film transistor TFT through a first contact hole CT1 penetrating the gate insulating layer 130, the first interlayer insulating layer 141, and the second interlayer insulating layer 142. The first data metal layer may be formed as a single layer or multiple layers made of molybdenum (Mo), aluminium (Al), chromium (Cr), gold (Au), titanium (Ti), nickel (Ni), neodymium (Nd), and/or copper (Cu), and/or an alloy thereof.

The first organic layer 160 for flattening the stepped portion due to the thin film transistors TFT may be disposed on the first connection electrode CE1 and the second interlayer insulating layer 142. The first organic layer 160 may be formed of an organic layer such as acryl resin, epoxy resin, phenolic resin, polyamide resin, polyimide resin, and/or the like.

The second data metal layer including a second connection electrode CE2 may be disposed on the first organic layer 160. The second data metal layer may be connected to the first connection electrode CE1 through a second contact hole CT2 penetrating the first organic layer 160. The second data metal layer may be formed as a single layer or multiple layers made of molybdenum (Mo), aluminium (Al), chromium (Cr), gold (Au), titanium (Ti), nickel (Ni), neodymium (Nd), and/or copper (Cu), and/or an alloy thereof.

The second organic layer 180 may be disposed on the second connection electrode CE2 and the first organic layer 160. The second organic layer 180 may be formed of an organic layer such as acryl resin, epoxy resin, phenolic resin, polyamide resin, polyimide resin, and/or the like.

In one or more embodiments, the second data metal layer including the second connection electrode CE2 and the second organic layer 180 may be omitted.

The light emitting element layer EML is disposed on the thin film transistor layer TFTL. The light emitting element layer EML may include light emitting elements LEL and a pixel defining layer 190.

Each of the light emitting elements LEL may include a pixel electrode 171, a light emitting layer 172, and a common electrode 173. Each of the emission areas EA is an area in which the pixel electrode 171, the light emitting layer 172, and the common electrode 173 are sequentially stacked such that the holes from the pixel electrode 171 and the electrons from the common electrode 173 are combined with each other in the light emitting layer 172 to emit light. In this case, the pixel electrode 171 may be an anode electrode, and the common electrode 173 may be a cathode electrode.

A pixel electrode layer including the pixel electrode 171 may be formed on the second organic layer 180. The pixel electrode 171 may be connected to the second connection electrode CE2 through a third contact hole CT3 penetrating the second organic layer 180. The pixel electrode layer may be formed as a single layer or multiple layers made of molybdenum (Mo), aluminium (Al), chromium (Cr), gold (Au), titanium (Ti), nickel (Ni), neodymium (Nd), and/or copper (Cu), and/or an alloy thereof.

In a top emission structure that emits light toward the common electrode 173 with respect to the light emitting layer 172, the pixel electrode 171 may be formed of a single layer of molybdenum (Mo), titanium (Ti), copper (Cu), and/or aluminium (Al), or may be formed to have a stacked structure (Ti/Al/Ti) of aluminium and titanium, a stacked structure (ITO/AI/ITO) of aluminium and ITO, an APC alloy, and/or a stacked structure (ITO/APC/ITO) of APC alloy and ITO to increase the reflectivity. The APC alloy is an alloy of silver (Ag), palladium (Pd), and copper (Cu).

The pixel defining layer 190 serves to define emission areas EA of pixels. To this end, the pixel defining layer 190 may be formed to expose a partial region of the pixel electrode 171 on the second organic layer 180. The pixel defining layer 190 may cover an edge of the pixel electrode 171. The pixel defining layer 190 may be disposed in the third contact hole CT3. That is, the third contact hole CT3 may be filled with the pixel defining layer 190. The pixel defining layer 190 may be formed of an organic layer such as acryl resin, epoxy resin, phenolic resin, polyamide resin, polyimide resin, and/or the like.

A spacer 191 may be disposed on the pixel defining layer 190. The spacer 191 may serve to support a mask during a process of manufacturing the light emitting layer 172. The spacer 191 may be formed of an organic layer such as acryl resin, epoxy resin, phenolic resin, polyamide resin, polyimide resin, and/or the like.

The light emitting layer 172 is formed on the pixel electrode 171. The light emitting layer 172 may include an organic material to emit light in a desired color (e.g., a predetermined color). For example, the light emitting layer 172 may include a hole transporting layer, an organic material layer, and an electron transporting layer. The organic material layer may include a host and a dopant. The organic material layer may include a material that emits desired light (e.g., predetermined light), and may be formed using a phosphorescent material and/or a fluorescent material.

The common electrode 173 is formed on the light emitting layer 172. The common electrode 173 may be formed to cover the light emitting layer 172. The common electrode 173 may be a common layer formed in common on the emission areas EA. A capping layer may be formed on the common electrode 173.

In the top emission structure, the common electrode 173 may be formed of a transparent conductive material (TCO) such as ITO and/or IZO capable of transmitting light or a semi-transmissive conductive material such as magnesium (Mg), silver (Ag), and/or an alloy of magnesium (Mg) and/or silver (Ag). When the common electrode 173 is formed of a semi-transmissive conductive material, the light emission efficiency can be increased due to a micro-cavity effect.

The encapsulation layer ENC may be disposed on the light emitting element layer EML. The encapsulation layer ENC may include at least one inorganic layer TFE1 and TFE3 to prevent oxygen or moisture from permeating into the light emitting element layer EML. In addition, the encapsulation layer ENC may include at least one organic layer TFE2 to protect the light emitting element layer EML from foreign substances such as dust. For example, the encapsulation layer ENC may include a first encapsulation inorganic layer TFE1, an encapsulation organic layer TFE2, and a second encapsulation inorganic layer TFE3.

The first encapsulation inorganic layer TFE1 may be disposed on the common electrode 173, the encapsulation organic layer TFE2 may be disposed on the first encapsulation inorganic layer TFE1, and the second encapsulation inorganic layer TFE3 may be disposed on the encapsulation organic layer TFE2. The first encapsulation inorganic layer TFE1 and the second encapsulation inorganic layer TFE3 may be formed of a multilayer in which one or more inorganic layers of a silicon nitride layer, a silicon oxynitride layer, a silicon oxide layer, a titanium oxide layer, and/or an aluminium oxide layer are alternately stacked. The encapsulation organic layer TFE2 may be an organic layer such as acryl resin, epoxy resin, phenolic resin, polyamide resin, polyimide resin, and/or the like.

The sensor electrode layer SENL may be disposed on the encapsulation layer ENC. The sensor electrode layer SENL may include a second buffer layer BF2, a first connection portion BE1, a first sensor insulating layer TINS1, sensor electrodes TE and RE, and a second sensor insulating layer TINS2.

The second buffer layer BF2 may be disposed on the encapsulation layer ENC. The second buffer layer BF2 may include at least one inorganic layer. For example, the second buffer layer BF2 may be formed of multiple layers in which one or more inorganic layers of a silicon nitride layer, a silicon oxynitride layer, a silicon oxide layer, a titanium oxide layer, and/or an aluminium oxide layer are alternately stacked. The second buffer layer BF2 may be omitted.

The first connection portions BE1 may be disposed on the second buffer layer BF2. The first connection portions BE1 may be formed of a single layer containing molybdenum (Mo), titanium (Ti), copper (Cu), and/or aluminium (Al), and/or may be formed to have a stacked structure (Ti/Al/Ti) of aluminium and titanium, a stacked structure (ITO/AI/ITO) of aluminium and indium tin oxide (ITO), an Ag-Pd-Cu (APC) alloy, and/or a stacked structure (ITO/APC/ITO) of APC alloy and ITO.

The first sensor insulating layer TINS1 may be disposed on the first connection portions BE1 and the second buffer layer BF2. The first sensor insulating layer TINS1 may be formed of an inorganic layer, for example, a silicon nitride layer, a silicon oxynitride layer, a silicon oxide layer, a titanium oxide layer, and/or an aluminium oxide layer.

The sensor electrodes, that is, the driving electrodes TE and the sensing electrodes RE may be disposed on the first sensor insulating layer TINS1. In one or more embodiments, the driving electrodes TE may be connected to the first connection portions BE1 via contact holes TCNT1 penetrating the first sensor insulating layer TINS1. In addition, dummy patterns may be disposed on the first sensor insulating layer TIIS1. The driving electrodes TE, the sensing electrodes RE, and the dummy patterns do not overlap the emission areas EA. The driving electrodes TE, the sensing electrodes RE, and the dummy patterns may be formed of a single layer containing molybdenum (Mo), titanium (Ti), copper (Cu), and/or aluminium (Al), or may be formed to have a stacked structure (Ti/Al/Ti) of aluminium and titanium, a stacked structure (ITO/AI/ITO) of aluminium and indium tin oxide (ITO), an Ag-Pd-Cu (APC) alloy, and/or a stacked structure (ITO/APC/ITO) of APC alloy and ITO.

The second sensor insulating layer TINS2 may be disposed on the driving electrodes TE, the sensing electrodes RE, the dummy patterns, and the first sensor insulating layer TNIS1. The second sensor insulating layer TINS2 may include at least one of an inorganic layer or an organic layer. The inorganic layer may be a silicon nitride layer, a silicon oxynitride layer, a silicon oxide layer, a titanium oxide layer, and/or an aluminium oxide layer. The organic layer may include acryl resin, epoxy resin, phenolic resin, polyamide resin, and/or polyimide resin.

The polarizing film PF may be disposed on the sensor electrode layer SENL. The polarizing film PF may be disposed on the display panel 100 to reduce reflection of external light. The polarizing film PF may include a first base member, a linear polarization plate, a phase retardation film such as a quarter-wave plate (λ/4 plate), and/or a second base member. The first base member, the phase retardation film, the linear polarization plate, and/or the second base member of the polarizing film PF may be sequentially stacked on the display panel 100.

The cover window CW may be disposed on the polarizing film PF. The cover window CW may be attached onto the polarizing film PF by a transparent adhesive member such as an optically clear adhesive (OCA) film.

The display device 10 according to the present embodiment includes the residue trace RSD. The residue trace RSD may be disposed on the display panel 100. For example, as illustrated in the drawings, the residue trace RSD may be disposed on the sensor electrode layer SENL. In one or more embodiments, the residue trace RSD may be disposed on the second sensor insulating layer TINS2.

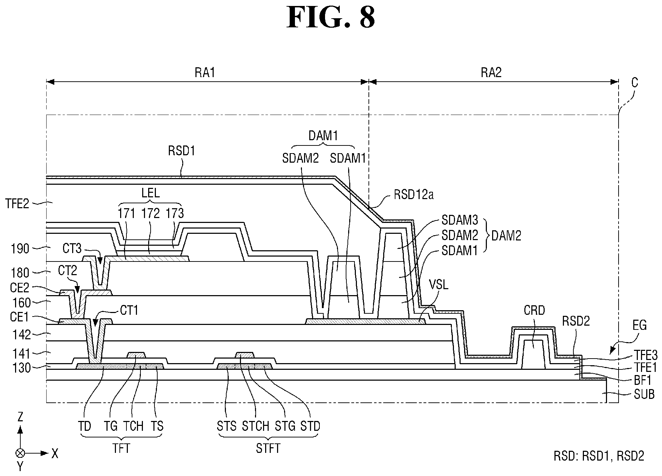

However, the present disclosure is not limited thereto, and when the display device 10 does not include the sensor electrode layer SENL, the residue trace RSD may be disposed on the encapsulation layer ENC. In one or more other embodiments, the residue trace RSD may be disposed on the second encapsulation inorganic layer TFE3 (see FIG. 8).

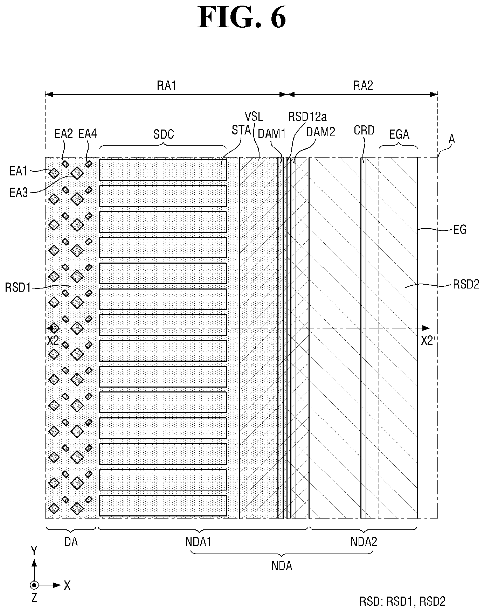

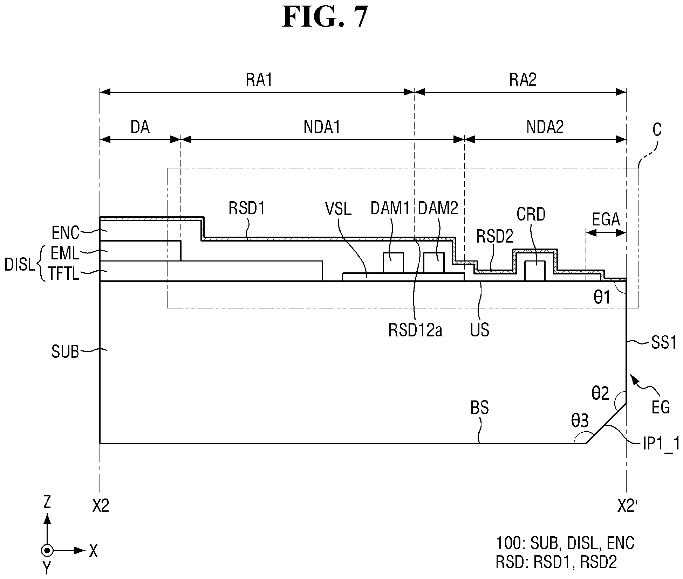

FIG. 6 is an enlarged view of an area A of FIG. 2. FIG. 7 is a cross-sectional view taken along the line X2-X2' of FIG. 6.

Referring to FIGS. 6 and 7 in addition to FIG. 5, the display area DA may include a plurality of emission areas EA1, EA2, EA3, and EA4. The plurality of emission areas EA1, EA2, EA3, and EA4 may include the first emission area EA1 emitting light of a first color, the second emission area EA2 and the fourth emission area EA4 emitting light of a second color, and the third emission area EA3 emitting light of a third color. For example, light of the first color may be light in a red wavelength band of approximately 600 nm to 750 nm, light of the second color may be light in a green wavelength band of approximately 480 nm to 560 nm, and light of the third color may be light in a blue wavelength band of approximately 370 nm to 460 nm, but the present disclosure is not limited thereto.

Although FIG. 6 illustrates that the second emission area EA2 and the fourth emission area EA4 emit light of the same color, that is, light of the second color, the present disclosure is not limited thereto. The second emission area EA2 and the fourth emission area EA4 may emit light of different colors. For example, the second emission area EA2 may emit light of the second color, and the fourth emission area EA4 may emit light of a fourth color.

In addition, in FIG. 6, although it is illustrated that each of the first emission areas EA1, the second emission areas EA2, the third emission areas EA3, and the fourth emission areas EA4 has a rectangular planar shape, the present disclosure is not limited thereto. Each of the first emission areas EA1, the second emission areas EA2, the third emission areas EA3, and the fourth emission areas EA4 may have a polygonal shape other than a quadrilateral shape, a circular shape, and/or an elliptical shape in a plan view.

In one or more embodiments, the third emission area EA3 may have the largest area, and the second emission area EA2 and the fourth emission area EA4 may have the smallest areas. The area of the second emission area EA2 and the area of the fourth emission area EA4 may be substantially the same (e.g., the same), but are not limited thereto.

The second emission areas EA2 and the fourth emission areas EA4 may be alternately disposed along the first direction (X-axis direction). The second emission areas EA2 may be disposed along the second direction (Y-axis direction). The fourth emission areas EA4 may be disposed along the second direction (Y-axis direction).

The first emission areas EA1 and the third emission areas EA3 may be alternately disposed along the first direction (X-axis direction). The first emission areas EA1 may be disposed along the second direction (Y-axis direction). The third emission areas EA3 may be disposed along the second direction (Y-axis direction). Each of the first emission areas EA1 and the third emission areas EA3 may have a square planar shape, but the present disclosure is not limited thereto.

The non-display area NDA may include a first non-display area NDA1 and a second non-display area NDA2. The first non-display area NDA1 may be an area in which structures for driving pixels of the display area DA are disposed. The second non-display area NDA2 may be disposed outside the first non-display area NDA1. In one or more embodiments, the second non-display area NDA2 may be an area outside the non-display area NDA. In addition, in one or more embodiments, the second non-display area NDA2 may be an area outside the display panel 100.

The first non-display area NDA1 may include a scan driving circuit unit SDC, a first power line VSL, a first dam DAM1, and a second dam DAM2.

The scan driving circuit unit SDC may include a plurality of stages STA. The plurality of stages STA may be connected to scan lines of the display area DA extending in the first direction (X-axis direction), respectively. That is, the plurality of stages STA may be connected one-to-one to the scan lines of the display area DA extending in the first direction (X-axis direction). The plurality of stages STA may sequentially apply scan signals to the plurality of scan lines.

The first power line VSL may be disposed outside the scan driving circuit unit SDC. That is, the first power line VSL may be disposed closer to an edge EG of the display panel 100 than the scan driving circuit unit SDC. The first power line VSL may extend in the second direction (Y-axis direction) in the non-display area NDA on the left side (or the right side) of the display panel 100.

The first power line VSL may be electrically connected to the common electrode 173, so that the common electrode 173 may be supplied with the first source voltage from the first power line VSL.

The first dam DAM1 and the second dam DAM2 may be structures for preventing the overflow of the encapsulation organic layer TFE2 of the encapsulation layer ENC into the edge EG of the display panel 100.

The first dam DAM1 may be disposed to be around (e.g., to surround) the display area DA, and the second dam DAM2 may be disposed to be around (e.g., to surround) the first dam DAM1. For example, as illustrated in FIG. 6, the first dam DAM1 and the second dam DAM2 may extend in the second direction (Y-axis direction) in the non-display area NDA on the right side of the display panel 100. The second dam DAM2 may be disposed outside the first dam DAM1. In one or more embodiments, the first dam DAM1 and the second dam DAM2 may also be disposed in the non-display area NDA on the upper side, lower side, and left side of the display panel 100. The first dam DAM1 and the second dam DAM2 may extend in the second direction (Y-axis direction) in the non-display area NDA on the left side (or the right side) of the display panel 100, and may extend in the first direction (X-axis direction) in the non-display area NDA on the upper side and the lower side of the display panel 100.

The first dam DAM1 may be disposed closer to the scan driving circuit unit SDC than the second dam DAM2 is, and the second dam DAM2 may be disposed closer to the edge EG of the display panel 100 than the first dam DAM1 is.

Although FIG. 6 illustrates that the first dam DAM1 and the second dam DAM2 are disposed on the first power line VSL, the present disclosure is not limited thereto. For example, either one of the first dam DAM1 and the second dam DAM2 may not be disposed on the first power line VSL. Alternatively, neither the first dam DAM1 nor the second dam DAM2 may be disposed on the first power line VSL. In this case, the first dam DAM1 and the second dam DAM2 may be disposed outside the first power line VSL.

In addition, although FIG. 6 illustrates that the display panel 100 according to one or more embodiments includes two dams DAM1 and DAM2, the present disclosure is not limited thereto. That is, the display panel 100 according to one or more embodiments may include three or more dams.

The second non-display area NDA2 may include a crack dam CRD and an edge area EGA.

The crack dam CRD may be a structure for preventing cracks from propagating in a process of cutting the substrate SUB during the manufacturing process of the display device 10. For example, the crack dam CRD may be a structure for preventing crack propagation of inorganic layers of the encapsulation layer ENC.

The crack dam CRD may be disposed in the second non-display area NDA2 and may be disposed outside the first dam DAM1 and the second dam DAM2. For example, the crack dam CRD may be disposed closer to the edge EG of the display panel 100 than the first dam DAM1 and the second dam DAM2 are.

The crack dam CRD may be disposed along left, upper, and right edges of the display panel 100. For example, as illustrated in FIG. 6, the crack dam CRD may extend in the second direction (Y-axis direction) in the non-display area NDA on the right side of the display panel 100. In one or more embodiments, the crack dam CRD may also be disposed in the non-display area NDA on the upper side and the left side of the display panel 100. The crack dam CRD may extend in the second direction (Y-axis direction) in the non-display area NDA on the left side of the display panel 100, and may extend in the first direction (X-axis direction) in the non-display area NDA on the upper side of the display panel 100. The crack dam CRD may not be disposed on the lower edge of the display panel 100. However, the present disclosure is not limited thereto, and in one or more other embodiments, the crack dam CRD may also be disposed in the non-display area NDA below the display panel 100, and in this case, the crack dam CRD may extend in the first direction (X-axis direction).

The edge area EGA may be disposed along the edge EG of the display panel 100. The edge area EGA may be an area in which processing traces generated in a process of cutting the substrate SUB are generated. For example, the edge area EGA may be an area where, when the substrate SUB is cut by spraying an etchant after being irradiated with a laser by a laser processing device, processing traces are formed on the top surface US of the substrate SUB due to etchant permeation. The width of the edge area EGA may be within about 30 µm, but is not limited thereto.

As shown in FIG. 7, the edge area EGA may include a first inclined surface IP1_1 formed by spraying the etchant after laser irradiation. An angle θ1 formed between a first side surface SS1 and a top surface US of the substrate SUB may be approximately 90 degrees. That is, the angle formed between the first side surface SS1 and the top surface US may be substantially close to a right angle. An angle θ2 between the first side surface SS1 and the first inclined surface IP1_1 and an angle θ3 between the first inclined surface IP1_1 and a bottom surface BS may be obtuse angles. The processing traces formed on the top surface US of the substrate SUB may overlap the first inclined surface IP1_1 in the third direction (Z-axis direction).

However, the present disclosure is not limited thereto, and in one or more embodiments, the first inclined surface IP1_1 may be omitted. Depending on the manufacturing process of the display device 10, the first inclined surface IP1_1 may not be formed, and only the first side surface SS1 may be disposed between the top surface US and the bottom surface BS of the substrate SUB. In addition, the first side surface SS1 may have a curved shape as well as a flat surface. Hereinafter, for simplicity of description, a case including the first inclined surface IP1_1 will be described as an example.

When the substrate SUB of the display panel 100 is cut by spraying the etchant after the irradiation of the laser, the minimum distance from the crack dam CRD to the edge EG of the display panel 100 may be reduced as compared to the case of performing a polishing process after cutting the substrate SUB with a cutting member. Accordingly, when the substrate SUB of the display panel 100 is cut by spraying the etchant after laser irradiation, the width of the second non-display area NDA2 may be greatly reduced. That is, the width of the non-display area NDA may be reduced or minimized.

In the display device 10 according to the present embodiment, the residue trace RSD may be disposed over the display area DA and the non-display area NDA. For example, the residue trace RSD may be disposed in the display area DA, the first non-display area NDA1, and the second non-display area NDA2.

In one or more embodiments, as shown in the drawings (e.g., FIG. 7), the first residue trace RSD1 may be disposed in the display area DA and the first non-display area NDA1, and the second residue trace RSD2 may be disposed in the first non-display area NDA1 and the second non-display area NDA2. However, the present disclosure is not limited thereto. In one or more other embodiments, the first residue trace RSD1 may be disposed in the display area DA, the first non-display area NDA1, and the second non-display area NDA2, and the second residue trace RSD2 may be disposed in the second non-display area NDA2.

In one or more embodiments, as shown in FIGS. 6 and 7, the first residue trace RSD1 may be disposed on the plurality of emission areas EA1, EA2, EA3, and EA4, the scan driving circuit unit SDC, the first power line VSL, and the first dam DAM1. The first residue trace RSD1 may overlap the plurality of emission areas EA1, EA2, EA3, and EA4, the scan driving circuit unit SDC, the first power line VSL, and the first dam DAM1 in the third direction (Z-axis direction). The second residue trace RSD2 may be disposed on the second dam DAM2, the crack dam CRD, and the edge area EGA. The second residue trace RSD2 may overlap the second dam DAM2, the crack dam CRD, and the edge area EGA in the third direction (Z-axis direction).

The display device 10 may include a first residue area RA1, which is an area where the first residue trace RSD1 is disposed, and a second residue area RA2, which is an area where the second residue trace RSD2 is disposed.

In one or more embodiments, as shown in the drawings (e.g., FIG. 6), an outer boundary RSD12a of the first residue trace RSD1 and the second residue trace RSD2 may be disposed along the left, upper, right, and lower edges of the display panel 100. For example, as shown in FIG. 6, the outer boundary RSD12a of the first residue trace RSD1 and the second residue trace RSD2 may extend in the second direction (Y-axis direction) in the non-display area NDA on the right side of the display panel 100. In one or more embodiments, the outer boundary RSD12a of the first residue trace RSD1 and the second residue trace RSD2 may extend in the second direction (Y-axis direction) in the non-display area NDA on the left side of the display panel 100, and may extend in the first direction (X-axis direction) in the non-display area NDA on the upper and lower sides of the display panel 100.

The second residue trace RSD2 may be located on the top and side surfaces of the layers disposed below the second residue trace RSD2. For example, as shown in the drawing (e.g., FIG. 7), when the second residue trace RSD2 is located on the encapsulation layer ENC, the second residue trace RSD2 may be located on the top and side surfaces of the encapsulation layer ENC. In one or more other embodiments, when the second residue trace RSD2 is located on the sensor electrode layer SENL, the residue trace RSD2 may be located on the top and side surfaces of the sensor electrode layer SENL (e.g., see FIG. 4).

When an area, in which the encapsulation layer ENC is not disposed on the substrate SUB, exists, the second residue trace RSD2 may be located on the top surface US of the substrate SUB. For example, as shown in FIG. 7, when the encapsulation layer ENC is not disposed in the edge area EGA and thus the top surface US of the substrate SUB is exposed, the second residue trace RSD2 may be disposed on the exposed top surface US of the substrate SUB.

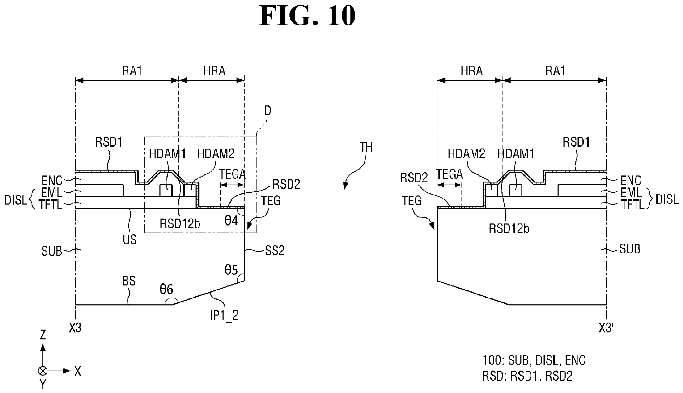

In one or more embodiments, the display device 10 may include the outer boundary RSD12a of the first residue trace RSD1 and the second residue trace RSD2 and an inner boundary RSD12b (see FIG. 10) of the first residue trace RSD1 and the second residue trace RSD2. The outer boundary RSD12a of the first residue trace RSD1 and the second residue trace RSD2 may refer to a boundary portion of the first residue trace RSD1 and the second residue trace RSD2 located adjacent to the edge EG of the display panel 100. The inner boundary RSD12b of the first residue trace RSD1 and the second residue trace RSD2 may refer to a boundary portion of the first residue trace RSD1 and the second residue trace RSD2 located adjacent to an edge TEG (see FIG. 10) of the through hole TH (see FIG. 10). The inner boundary RSD12b (see FIG. 10) of the first residue trace RSD1 and the second residue trace RSD2 will be described later with reference to FIG. 10. Hereinafter, the outer boundary RSD12a of the first residue trace RSD1 and the second residue trace RSD2 will be described.

The outer boundary RSD12a of the first residue trace RSD1 and the second residue trace RSD2 may be disposed inward from the crack dam CRD. For example, the outer boundary RSD12a of the first residue trace RSD1 and the second residue trace RSD2 may be located inward from the crack dam CRD at the left, upper, right, and lower edges of the display panel 100. In one or more embodiments, as shown in the drawings (e.g., FIG. 7), the outer boundary RSD12a of the first residue trace RSD1 and the second residue trace RSD2 may be located between the first dam DAM1 and the second dam DAM2. However, the present disclosure is not limited thereto. In one or more other embodiments, the outer boundary RSD12a of the first residue trace RSD1 and the second residue trace RSD2 may be disposed between the second dam DAM2 and the crack dam CRD.

The first residue trace RSD1 of the display device 10 according to the present embodiment may be formed by removing the coating layer CTL (see FIG. 16) in the manufacturing method S1 (see FIG. 13) for a display device to be described later. By including the coating layer CTL (see FIG. 16), it is not necessary to perform a process for cutting a separate protective film. Accordingly, process efficiency and process yield may be improved. This will be described later with reference to FIG. 13.

The second residue trace RSD2 of the display device 10 according to the present embodiment may be formed by removing the acid resistant layer PRL (see FIG. 17) in the manufacturing method S1 (see FIG. 13) for a display device to be described later. By including the acid resistant layer PRL (see FIG. 17), the width of the edge area EGA formed by etchant penetration may be reduced or minimized. Accordingly, the width of the non-display area NDA of the display device 10 may be reduced or minimized. This will be described later with reference to FIG. 13.

FIG. 8 is an enlarged view of an area C of FIG. 7.

Referring to FIG. 8, the crack dam CRD may include the same material as the first organic layer 160. The crack dam CRD may be disposed on the first buffer layer BF1. The crack dam CRD may be formed of an organic layer such as acryl resin, epoxy resin, phenolic resin, polyamide resin, polyimide resin, and/or the like.

Although FIG. 8 illustrates that the crack dam CRD includes one organic layer, the present disclosure is not limited thereto. For example, the crack dam CRD may further include another organic layer including the same material as the second organic layer 180. Alternatively, the crack dam CRD may further include another organic layer including the same material as the pixel defining layer 190. Alternatively, the crack dam CRD may further include another organic layer including the same material as the spacer 191 (see FIG. 5).

The first power line VSL may include the same material as the first data metal layer including the first connection electrode CE1 and the data lines and may be disposed on the same layer (e.g., at the same layer). The first power line VSL may be disposed on the second interlayer insulating layer 142. The first power line VSL may be formed as a single layer or multiple layers made of molybdenum (Mo), aluminium (Al), chromium (Cr), gold (Au), titanium (Ti), nickel (Ni), neodymium (Nd), and/or copper (Cu), and/or an alloy thereof.

The first dam DAM1 and the second dam DAM2 may be disposed on the first power line VSL. The first dam DAM1 may include a first sub-dam SDAM1 and a second sub-dam SDAM2, and the second dam DAM2 may include a first sub-dam SDAM1, a second sub-dam SDAM2, and a third sub-dam SDAM3. The first sub-dam SDAM1 and the first organic layer 160 may include the same material, and may be disposed on the same layer (e.g., at the same layer). The second sub-dam SDAM2 and the second organic layer 180 may include the same material, and may be disposed on the same layer (e.g., at the same layer). The third sub-dam SDAM3 may include the same material as the pixel defining layer 190 and may be disposed on the same layer (e.g., at the same layer).

The height of the first dam DAM1 may be lower than the height of the second dam DAM2, but the present disclosure is not limited thereto. The height of the first dam DAM1 may be substantially the same as the height of the second dam DAM2 or may be higher than the height of the second dam DAM2.

The common electrode 173 may be connected to the first power line VSL exposed without being covered by the first organic layer 160, the second organic layer 180, and the first dam DAM1. Accordingly, the common electrode 173 may be supplied with the first source voltage of the first power line VSL.

The first encapsulation inorganic layer TFE1 may cover the first dam DAM1, the second dam DAM2, and the crack dam CRD in the non-display area NDA. In one or more embodiments, the first encapsulation inorganic layer TFE1 may extend adjacent to the edge EG of the display panel 100 in the non-display area NDA. In the drawings (e.g., FIG. 8), the lateral side of the first encapsulation inorganic layer TFE1 is shown as being located between the crack dam CRD and the lateral side of the substrate SUB, but may be disposed to be aligned with the lateral side of the substrate SUB to coincide therewith, without being limited thereto.

In one or more other embodiments, the first encapsulation inorganic layer TFE1 may not cover at least one of the second dam DAM2 or the crack dam CRD. For example, the first encapsulation inorganic layer TFE1 may not cover the crack dam CRD. One end of the first encapsulation inorganic layer TFE1 may be disposed inside the crack dam CRD.

The encapsulation organic layer TFE2 may be disposed to cover the top surface of the first dam DAM1 without covering the top surface of the second dam DAM2. However, the present disclosure is not limited thereto. The encapsulation organic layer TFE2 may not cover both the top surface of the first dam DAM1 and the top surface of the second dam DAM2. The encapsulation organic layer TFE2 may not overflow to the edge EG of the display panel 100 due to the first dam DAM1 and the second dam DAM2.

The second encapsulation inorganic layer TFE3 may cover the first dam DAM1, the second dam DAM2, and the crack dam CRD in the non-display area NDA. In one or more embodiments, the second encapsulation inorganic layer TFE3 may extend adjacent to the edge EG of the display panel 100 in the non-display area NDA. The lateral side of the second encapsulation inorganic layer TFE3 is shown as being located between the crack dam CRD and the lateral side of the substrate SUB, but may be disposed to be aligned with the lateral side of the substrate SUB to coincide therewith, without being limited thereto.

In one or more other embodiments, the second encapsulation inorganic layer TFE3 may not cover at least one of the second dam DAM2 or the crack dam CRD. For example, the second encapsulation inorganic layer TFE3 may not cover the crack dam CRD. One end of the second encapsulation inorganic layer TFE3 may be disposed inside the crack dam CRD.

An inorganic encapsulation area in which the first encapsulation inorganic layer TFE1 and the second encapsulation inorganic layer TFE3 are in contact with each other may be formed from the second dam DAM2 to a region adjacent to the edge EG of the display panel 100. The inorganic encapsulation area may be disposed to be around (e.g., to surround) the second dam DAM2.

In FIG. 8, a scan thin film transistor STFT of the scan driving circuit unit SDC is shown as an example. Because the scan thin film transistor STFT is substantially the same as the thin film transistor TFT described in conjunction with FIG. 5, a description of the scan thin film transistor STFT will be omitted.

In the display device 10 according to the present embodiment, the thickness of the residue trace RSD (e.g., RSD1, RSD2) may be several nanometers to several tens of nanometers. In one or more embodiments, the first residue trace RSD1 and the second residue trace RSD2 may contain the same materials as the coating layer CTL (see FIG. 16) and the acid resistant layer PRL (see FIG. 17) in the manufacturing method for a display device (see FIG. 13) to be described later, respectively. In one or more other embodiments, the residue trace RSD may include the same material as the layer located under the residue trace RSD. For example, the residue trace RSD may include the same material as the second encapsulation inorganic layer TFE3 or the same material as the second sensor insulating layer TINS2 (e.g., see FIG. 5).

As an example, the first residue trace RSD1 and the second residue trace RSD2 may be formed with parts of the coating layer CTL (see FIG. 16) and the acid resistant layer PRL (see FIG. 17) remaining in the process of removing the coating layer CTL (see FIG. 16) and the acid resistant layer PRL (see FIG. 17), respectively. As another example, the residue trace RSD may be formed as a result of removing a part of a layer located below the residue trace RSD together with the coating layer CTL (see FIG. 16) and the acid resistant layer PRL (see FIG. 17) in the process of removing the coating layer CTL (see FIG. 16) and the acid resistant layer PRL (see FIG. 17).

In one or more embodiments, the first residue trace RSD1 may include the same material as the coating layer CTL (see FIG. 16) in the manufacturing method for a display device (see FIG. 13) to be described later, and the second residue trace RSD2 may include the same material as the acid resistant layer PRL (see FIG. 17). In one or more other embodiments, the first residue trace RSD1 and the second residue trace RSD2 may include the same materials as the layers located below the first residue trace RSD1 and the second residue trace RSD2, respectively. For example, the first residue trace RSD1 may include the same material as the second encapsulation inorganic layer TFE3 and/or the same material as the second sensor insulating layer TINS2. The second residue trace RSD2 may include the same material as the second encapsulation inorganic layer TFE3, the same material as the second sensor insulating layer TINS2, or the same material as the substrate SUB.

The material compositions included respectively in the first residue trace RSD1 and the second residue trace RSD2 may be different from each other. For example, the coating layer CTL (see FIG. 16) and the acid resistant layer PRL (see FIG. 17) may include different materials. Because the first residue trace RSD1 overlaps the display area DA, the coating layer CTL (see FIG. 16) may include a material having a higher light transmittance than that of the acid resistant layer PRL (see FIG. 17). Because the acid resistant layer PRL (see FIG. 17) has acid resistance to prevent permeation of an etchant, it may include a material having higher acid resistance than that of the coating layer CTL (see FIG. 16). This will be described later with reference to FIG. 13 and the like.

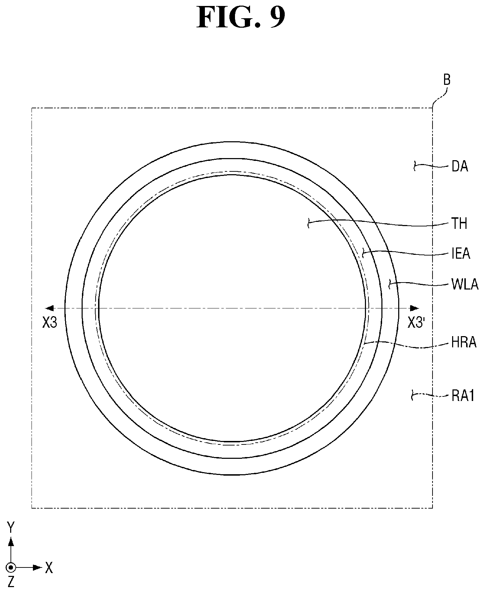

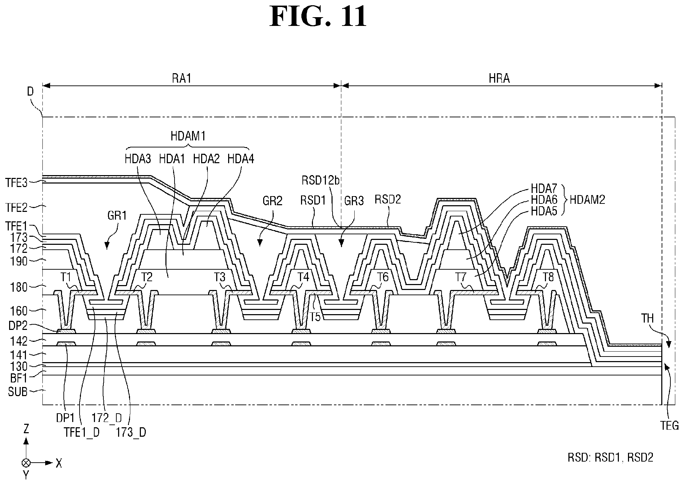

FIG. 9 is an enlarged view of an area B of FIG. 2. FIG. 10 is a cross-sectional view taken along the line X3-X3' of FIG. 9. FIG. 11 is an enlarged view of an area D of FIG. 10.

Referring to FIGS. 9 - 11, the display panel 100 according to one or more embodiments may include an inorganic encapsulation area IEA around (e.g., surrounding) the through hole TH and a wiring area WLA around (e.g., surrounding) the inorganic encapsulation area IEA.

The first encapsulation inorganic layer TFE1 and the second encapsulation inorganic layer TFE3 of the encapsulation layer ENC may be in contact with each other, so that the inorganic encapsulation area IEA may be a layer for preventing oxygen or moisture from permeating into the light emitting element layer EML of the display layer DISL due to the through hole TH.

The inorganic encapsulation area IEA may include at least one dam, at least one tip, and at least one groove. For example, as illustrated in FIG. 11, the inorganic encapsulation area IEA may include a first hole dam HDAM1, a second hole dam HDAM2, first to eighth tips T1 to T8, and first to third grooves GR1 to GR3.

The first tip T1 and the second tip T2 may be disposed closer to the wiring area WLA than the first hole dam HDAM1 is. The first tip T1 may be disposed closer to the wiring area WLA than the second tip T2. The second tip T2 may be disposed between the first tip T1 and the first hole dam HDAM1.

The third tip T3, the fourth tip T4, the fifth tip T5, and the sixth tip T6 may be disposed between the first hole dam HDAM1 and the second hole dam HDAM2. At least a part of the third tip T3 may overlap the first hole dam HDAM1 in the third direction (Z-axis direction).

The seventh tip T7 and the eighth tip T8 may be disposed closer to the through hole TH than the second hole dam HDAM2 is. At least a part of the seventh tip T7 may overlap the second hole dam HDAM2 in the third direction (Z-axis direction). The eighth tip T8 may be disposed between the second hole dam HDAM2 and the through hole TH.

The first groove GR1 may be disposed between the first tip T1 and the second tip T2. The second groove GR2 may be disposed between the third tip T3 and the fourth tip T4. The third groove GR3 may be disposed between the fifth tip T5 and the sixth tip T6.

The wiring area WLA may be an area in which bypass lines due to the through hole TH are disposed. Some of the bypass lines may be connected to data lines, and some others of the bypass lines may be connected to a second power line to which a second source voltage higher than the first source voltage is applied. Yet some others of the bypass lines may be connected to the scan lines. The wiring area WLA may be surrounded by the display area DA.

FIG. 10 illustrates a cross section of the edge TEG of the through hole TH formed when the substrate SUB is cut by spraying the etchant after laser irradiation by the laser processing device in the manufacturing process of the display device 10.

As illustrated in FIG. 10, when the substrate SUB is cut by spraying the etchant after laser irradiation by the laser processing device in the manufacturing process of the display device 10, a through hole edge area TEGA may be an area in which processing traces are formed on the top surface US of the substrate SUB. A width of the through hole edge area TEGA may be within approximately 30 µm, but is not limited thereto.

The through hole edge area TEGA may include a second inclined surface IP1_2 formed by spraying the etchant after laser irradiation. An angle θ4 between a second side surface SS2 of the edge TEG of the through hole TH and the top surface US of the substrate SUB may be within 90 degrees. That is, an angle between the second side surface SS2 of the edge TEG of the through hole TH and the top surface US of the substrate SUB may be substantially close to a right angle. An angle θ5 between the second side surface SS2 of the edge TEG of the through hole TH and the second inclined surface IP1_2 and an angle θ6 between the second inclined surface IP1_2 and the bottom surface BS may be obtuse angles. The processing traces formed on the top surface US of the substrate SUB may overlap the second inclined surface IP1_2 in the third direction (Z-axis direction).

The angle θ5 between the second side surface SS2 of the edge TEG of the through hole TH and the second inclined surface IP1_2 and the angle θ6 between the second inclined surface IP1_2 and the bottom surface BS of the substrate SUB may vary according to the depth of the laser irradiation area formed by the laser when the substrate SUB of the display panel 100 is cut by spraying the etchant after laser irradiation. The depth of the laser irradiation area formed by the laser to perform cutting along the edge EG (see FIG. 7 or the like) of the display panel 100 may be different from the depth of the laser irradiation area formed by the laser to perform cutting along the edge TEG of the through hole TH.

For example, the angle θ5 between the second side surface SS2 of the edge TEG of the through hole TH illustrated in FIG. 10 and the second inclined surface IP1_2 may be smaller than the angle θ2 between the first side surface SS1 and the first inclined surface IP1_1 illustrated in FIG. 7. The angle θ6 between the second inclined surface IP1_2 and the bottom surface BS of the substrate SUB illustrated in FIG. 10 may be greater than the angle θ3 between the first inclined surface IP1_1 and the bottom surface BS of the substrate SUB illustrated in FIG. 7.

As illustrated in FIG. 11, a first dummy pattern DP1 may include the same material as the second gate metal layer including the second capacitor electrode CAE2 of the capacitor Cst and may be disposed on the same layer (e.g., at the same layer). For example, the first dummy pattern DP1 may be disposed on the first interlayer insulating layer 141. The first dummy pattern DP1 may be formed as a single layer or multiple layers made of molybdenum (Mo), aluminium (Al), chromium (Cr), gold (Au), titanium (Ti), nickel (Ni), neodymium (Nd), and/or copper (Cu), and/or an alloy thereof.

A second dummy pattern DP2 may include the same material as the first data metal layer including the first connection electrode CE1 and the data lines and may be disposed on the same layer (e.g., at the same layer). For example, the second dummy pattern DP2 may be disposed on the second interlayer insulating layer 142. The second dummy pattern DP2 may be formed as a single layer or multiple layers made of molybdenum (Mo), aluminium (Al), chromium (Cr), gold (Au), titanium (Ti), nickel (Ni), neodymium (Nd), and/or copper (Cu), and/or an alloy thereof.

The second dummy pattern DP2 may overlap the first dummy pattern DP1 in the third direction (Z-axis direction).

The first to eighth tips T1 to T8 may include the same material as the second data metal layer including the second connection electrode CE2 and may be disposed on the same layer (e.g., at the same layer). For example, the first to eighth tips T1 to T8 may be disposed on the first organic layer 160. The first to eighth tips T1 to T8 may be formed as a single layer or multiple layers made of molybdenum (Mo), aluminium (Al), chromium (Cr), gold (Au), titanium (Ti), nickel (Ni), neodymium (Nd), and/or copper (Cu), and/or an alloy thereof.

Each of the first to eighth tips T1 to T8 may be connected to the second dummy pattern DP2 through a contact hole penetrating the first organic layer 160. Each of the first to eighth tips T1 to T8 may include an eaves structure in which the top surface and the bottom surface are exposed without being covered by the first organic layer 160, the second organic layer 180, the first hole dam HDAM1, and the second hole dam HDAM2. The fourth tip T4 and the fifth tip T5 may be integrally formed. Each of the first to eighth tips T1 to T8 may be a protruding pattern or a trench pattern for forming a groove (or trench).

The through hole edge area TEGA may be disposed between the eighth tip T8 and the edge TEG of the through hole TH.

The first groove GR1 may be formed between the first tip T1 and the second tip T2, the second groove GR2 may be formed between the third tip T3 and the fourth tip T4, and the third groove GR3 may be formed between the fifth tip T5 and the sixth tip T6. The first groove GR1 may have an eaves structure formed by the first tip T1 and the second tip T2, the second groove GR2 may have an eaves structure formed by the third tip T3 and the fourth tip T4, and the third groove GR3 may have an eaves structure formed by the fifth tip T5 and the sixth tip T6.

Because the light emitting layer 172 is deposited by evaporation and the common electrode 173 is deposited by sputtering, the light emitting layer 172 and the common electrode 173 may be disposed to be broken at each of the first to third grooves GR1, GR2, and GR3 because the step coverage is low. In contrast, the first encapsulation inorganic layer TFE1 and the second encapsulation inorganic layer TFE3 may be deposited by chemical vapor deposition, atomic layer deposition, or the like, and thus may be formed to be continuous without being broken in each of the first to third grooves GR1, GR2, and GR3 because the step coverage is high. Step coverage refers to the ratio of the degree of thin film coated on an inclined portion to the degree of thin film coated on a flat portion. A broken light emitting layer remnant 172_D, and a broken common electrode remnant 173_D may be disposed in the first to third grooves GR1, GR2, and GR3, respectively. In one or more embodiments, the broken light emitting layer remnant 172_D, the broken common electrode remnant 173_D, and a portion TFE1_D of the continuous first encapsulation inorganic layer TFE1 may be disposed in the first to third grooves GR1, GR2, and GR3, respectively (e.g., see FIG. 11).

The first hole dam HDAM1 may include first to fourth hole sub-dams HDA1, HDA2, HDA3, and HDA4. The first hole sub-dam HDA1 may be disposed on the first organic layer 160 and may include the same material as the second organic layer 180. The first hole sub-dam HDA1 may be disposed on the second tip T2 and the third tip T3. The second hole sub-dam HDA2 may be disposed on the first hole sub-dam HDA1 and may include the same material as the pixel defining layer 190. The third hole sub-dam HDA3 and the fourth hole sub-dam HDA4 may be disposed on the second hole sub-dam HDA2 and may include the same material as the spacer 191, but are not limited thereto. The fourth hole sub-dam HDA4 may be disposed closer to the through hole TH than the third hole sub-dam HDA3 is. The thickness of the fourth hole sub-dam HDA4 (e.g., in the third direction (e.g., Z-axis direction)) may be greater than the thickness of the third hole sub-dam HDA3.

The second hole dam HDAM2 may include fifth to seventh hole sub-dams HDA5, HDA6, and HDA7. The fifth hole sub-dam HDA5 may be disposed on the first organic layer 160 and may include the same material as the second organic layer 180. The fifth hole sub-dam HDA5 may be disposed on the seventh tip T7. The sixth hole sub-dam HDA6 may be disposed on the fifth hole sub-dam HDA5 and may include the same material as the pixel defining layer 190. The seventh hole sub-dam HDA7 may be disposed on the sixth hole sub-dam HDA6 and may include the same material as the spacer 191, but is not limited thereto.

The overflow of the encapsulation organic layer TFE2 into the through hole TH may be prevented by the first hole dam HDAM1 and the second hole dam HDAM2.

The light emitting layer remnant 172_D, the common electrode remnant 173_D, the first encapsulation inorganic layer TFE1, and the second encapsulation inorganic layer TFE3 may extend to the edge TEG of the through hole TH. The end of the light emitting layer remnant 172_D, the end of the common electrode remnant 173_D, the end of the first encapsulation inorganic layer TFE1, or the end of the second encapsulation inorganic layer TFE3 may coincide with the edge TEG of the through hole TH. However, the present disclosure is not limited thereto, and the end of the light emitting layer remnant 172_D, the end of the common electrode remnant 173_D, the end of the first encapsulation inorganic layer TFE1, or the end of the second encapsulation inorganic layer TFE3 may not coincide with the edge TEG of the through hole TH.

As illustrated in FIG. 11, because the light emitting layer 172 and the common electrode 173 are broken in the first to third grooves GR1, GR2, and GR3 formed by the first to eighth tips T1 to T8, respectively, it is possible to prevent the light emitting layer 172 and the common electrode 173 exposed through the through hole TH from being a path through which oxygen, moisture, or the like permeates.

In one or more embodiments, as shown in FIG. 9, the display device 10 according to the present embodiment may further include a hole residue area HRA.

The hole residue area HRA may be an area where the second residue trace RSD2 is disposed, and may be an area disposed adjacent to the through hole TH. The hole residue area HRA may be surrounded by the first residue area RA1. The hole residue area HRA may be an area where the acid resistant layer PRL (see FIG. 17) is disposed in the manufacturing method S1 (see FIG. 13) for a display device to be described later.

The first residue area RA1 may overlap the inorganic encapsulation area IEA and the wiring area WLA in the third direction (Z-axis direction). The first residue area RA1 may surround the through hole TH in a plan view. The first residue area RA1 may not overlap the through hole TH in the third direction (Z-axis direction).

The hole residue area HRA may be disposed to be around (e.g., to surround) the through hole TH. At least a part of the hole residue area HRA may overlap the through hole edge area TEGA in the third direction (Z-axis direction). The hole residue area HRA may be disposed inward from the first residue area RA1. In one or more embodiments, the hole residue area HRA may be disposed inward from the first hole dam HDAM1.

In one or more embodiments, the shape of the hole residue area HRA may conform to the shape of the through hole TH. For example, when the through hole TH is of a circular shape, the hole residue area HRA may also have a circular shape. However, the present disclosure is not limited thereto.

The residue trace RSD may not overlap the through hole TH. For example, the first residue trace RSD1 and the second residue trace RSD2 may be arranged to be around (e.g., to surround) the through hole TH from the outside of the through hole TH.

The residue trace RSD may be disposed on the first to eighth tips T1 to T8, the first hole dam HDAM1, and the second hole dam HDAM2. As an example, the first residue trace RSD1 may be disposed on the first to fifth tips T1 to T5 and the first hole dam HDAM1, and the second residue trace RSD2 may be disposed on the sixth to eighth tips T6 to T8 and the second hole dam HDAM2. As another example, the first residue trace RSD1 may be disposed on the first to eighth tips T1 to T8, the first hole dam HDAM1 and the second hole dam HDAM2, and the second residue trace RSD2 may be disposed between the eighth tip T8 and the edge TEG of the through hole.

In one or more embodiments, the inner boundary RSD12b of the first residue trace RSD1 and the second residue trace RSD2 may be around (e.g., may surround) the through hole TH. The inner boundary RSD12b of the first residue trace RSD1 and the second residue trace RSD2 may be a boundary between the first residue area RA1 and the hole residue area HRA. For example, the inner boundary RSD12b of the first residue trace RSD1 and the second residue trace RSD2 may be disposed outward from the perimeter of the through hole TH in a plan view. The inner boundary RSD12b of the first residue trace RSD1 and the second residue trace RSD2 may be disposed outward from the edge TEG of the through hole TH.

The second residue trace RSD2 of the display device 10 according to the present embodiment may be formed by removing the acid resistant layer PRL (see FIG. 17) in the manufacturing method S1 (see FIG. 13) for a display device to be described later. By including the acid resistant layer PRL (see FIG. 17), it is possible to reduce or minimize a width of a through hole edge area TEGA formed by etchant permeation. Accordingly, the width of the non-display area NDA of the display device 10 may be reduced or minimized. This will be described later with reference to FIG. 13.

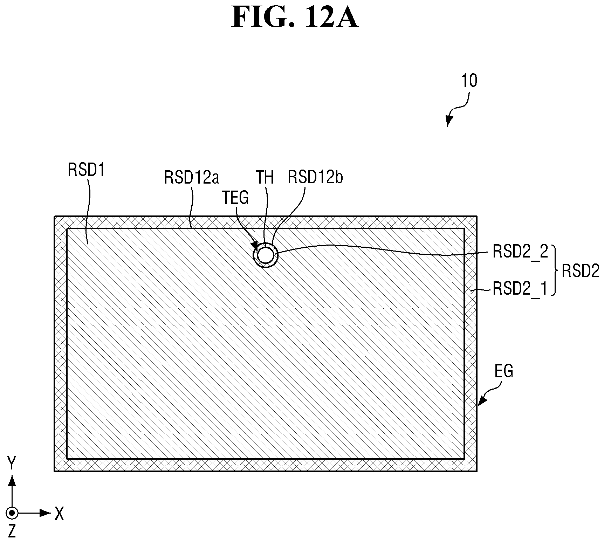

FIG. 12A is a plan view illustrating a residue trace of a display device according to one or more embodiments.

Referring to FIG. 12A in addition to FIGS. 6 - 11, the second residue trace RSD2 may include a first portion RSD2_1 and a second portion RSD2_2. The first portion RSD2_1 of the second residue trace RSD2 may be disposed adjacent to the edge EG of the display panel 100. The second portion RSD2_2 of the second residue trace RSD2 may be disposed adjacent to the edge TEG of the through hole TH.

The first portion RSD2_1 of the second residue trace RSD2 may be around (e.g., may surround) the first residue trace RSD1 in a plan view. The first residue trace RSD1 may be around (e.g., may surround) the second portion RSD2_2 of the second residue trace RSD2 in a plan view. The second portion RSD2_2 of the second residue trace RSD2 may be disposed in an opening of the first residue trace RSD1. The second portion RSD2_2 of the second residue trace RSD2 may be around (e.g. may surround) the through hole TH of the display panel 100 in a plan view.

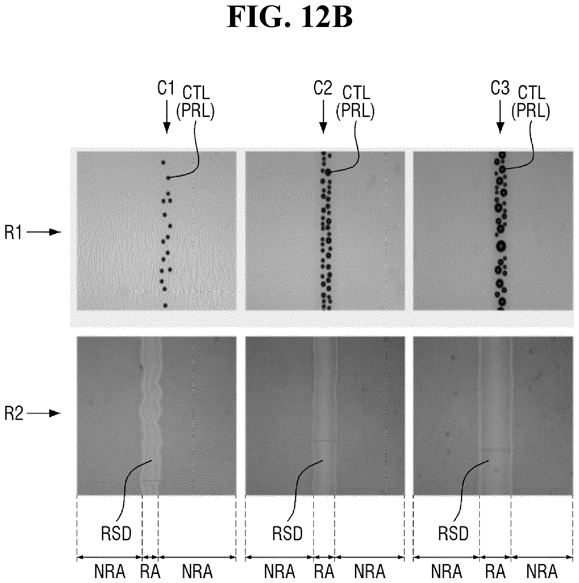

FIG. 12B presents photographs illustrating a process through which a residue trace of a display device according to one or more embodiments is formed.

Referring to FIG. 12B in addition to FIGS. 6 - 11, the residue trace RSD may be formed by removing the coating layer CTL or the acid resistant layer PRL in the manufacturing method S1 (see FIG. 13) for a display device to be described later. In one or more embodiments, the coating layer CTL may be formed by an inkjet printing process, and the acid resistant layer PRL may be formed by an inkjet printing, screen printing, and/or slit coating process. Hereinafter, the case where the coating layer CTL and the acid resistant layer PRL are formed by an inkjet printing process will be described as an example.

The photographs disposed in a first row R1 illustrate a state immediately after ink, which is a material of the coating layer CTL or the acid resistant layer PRL, is deposited on an arbitrary inorganic layer such as the second sensor insulating layer TINS2 or the second encapsulating inorganic layer TFE3. The photographs disposed in a second row R2 show a state of the arbitrary inorganic layer after the coating layer CTL or the acid resistant layer PRL is removed.

The shape of the residue trace of FIG. 12B is nothing more than an example, and the shape of the residue trace RSD is not limited to the shape shown in the drawing.

In the first row R1, the photographs disposed in a first column C1, a second column C2, and a third column C3 show states in which the ink is coated in different densities and different amounts depending on the width and the thickness of the coating layer CTL and/or the acid resistant layer PRL. For example, the coating layer CTL and/or acid resistant layer PRL in a first column C1 may have a smaller width and thickness than those of the coating layer CTL and/or acid resistant layer PRL in a second column C2. The coating layer CTL and/or acid resistant layer PRL in the second column C2 may have a smaller width and thickness than those of the coating layer CTL or acid resistant layer PRL in a third column C3.

In the second row R2, the photographs disposed in the first column C1, the second column C2, and the third column C3 respectively show the residue traces RSD formed as the coating layers CTL and/or the acid resistant layers PRL of the first column C1, the second column C2, and the third column C3 are removed. For example, the coating layer CTL and/or acid resistant layer PRL in a first row R1 and the first column C1 may be removed to form the residue trace RSD in a second row R2 and the first column C1. The coating layer CTL and/or acid resistant layer PRL in the first row R1 and the second column C2 may be removed to form the residue trace RSD in a second row R2 and the second column C2. The coating layer CTL and/or acid resistant layer PRL in the first row R1 and the third column C3 may be removed to form the residue trace RSD in the second row R2 and the third column C3.

The photographs in the first row R1 are taken through an optical microscope, and the photographs in the second row R2 are taken through a scanning electron microscope (SEM).

As illustrated in the drawings (e.g., FIG. 12B), the light transmittance of the residue area RA in which the residue trace RSD is disposed may be different from the light transmittance of the non-residue area NRA in which the residue trace RSD is not disposed. As an example, the light transmittance of the residue area RA in which the residue trace RSD is disposed may be lower than the light transmittance of the non-residue area NRA in which the residue trace RSD is not disposed. The residue area RA may include the first residue area RA1, the second residue area RA2, and the hole residue area HRA. The non-residue area NRA may include an area where the residue trace RSD is not disposed.

In one or more embodiments, the light transmittance of the first residue trace RSD1 may be higher than the light transmittance of the second residue trace RSD2. The light transmittance of the first residue area RA1 where the first residue trace RSD1 is disposed may be higher than the light transmittance of the second residue area RA2 where the second residue trace RSD2 is disposed and the hole residue area HRA. Because the first residue area RA1 where the first residue trace RSD1 is disposed overlaps the display area DA, and the second residue area RA2 and the hole residue area HRA where the second residue trace RSD2 is disposed overlap the non-display area NDA, the light transmittance of the first residue area RA1 may be higher than the light transmittance of the second residue area RA2 and the hole residue area HRA.

Hereinafter, a method for manufacturing a display device according to one or more embodiments will be described.

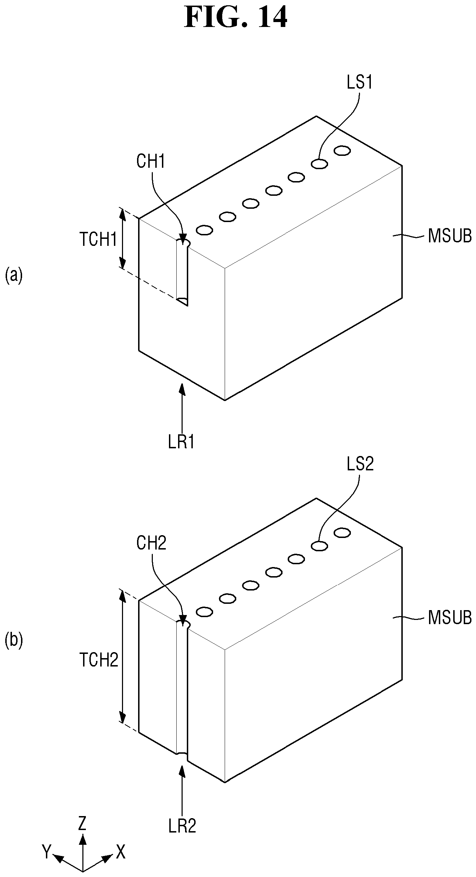

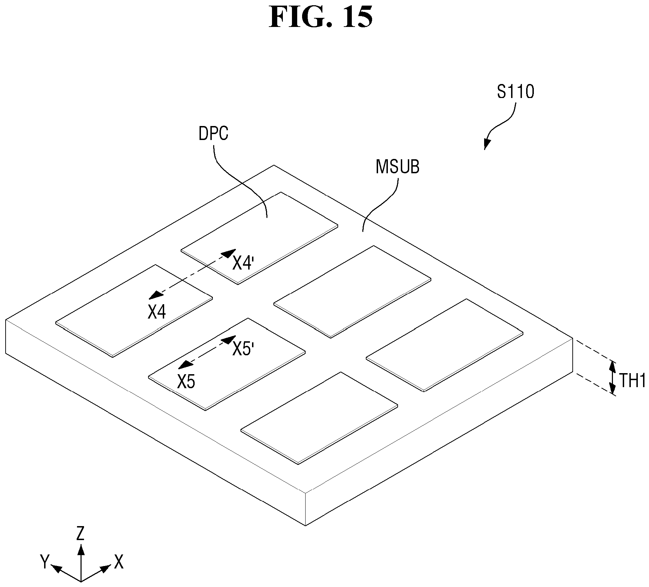

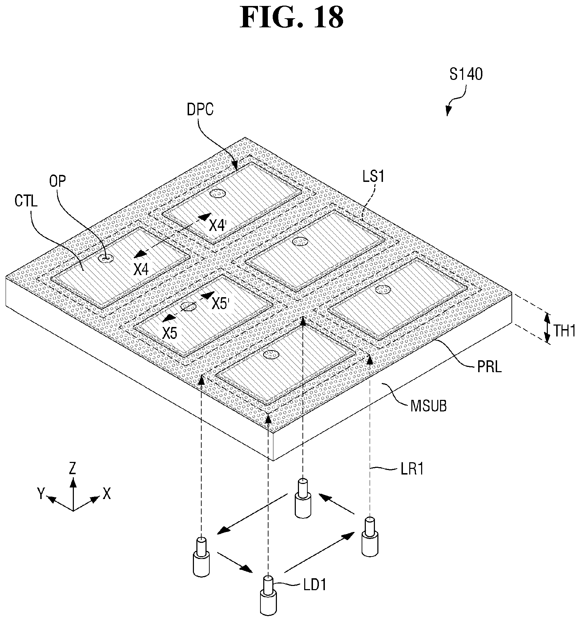

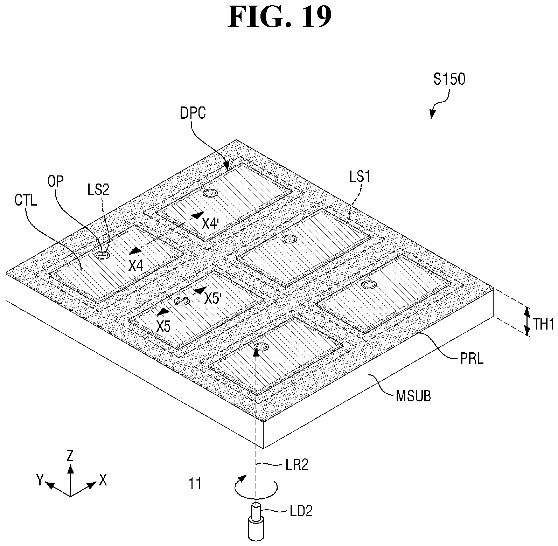

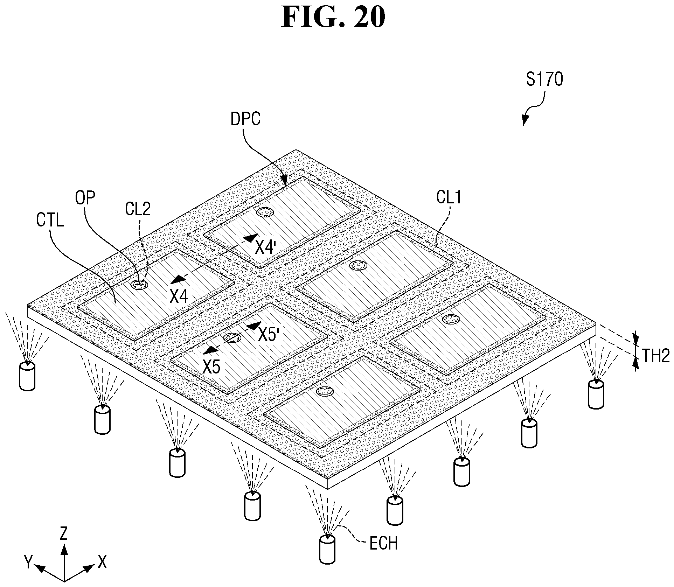

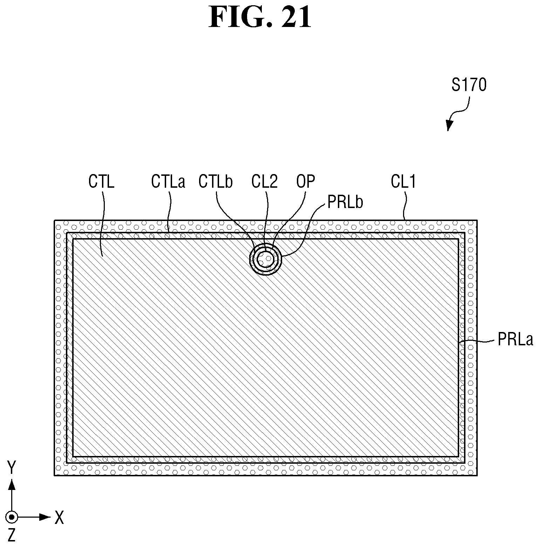

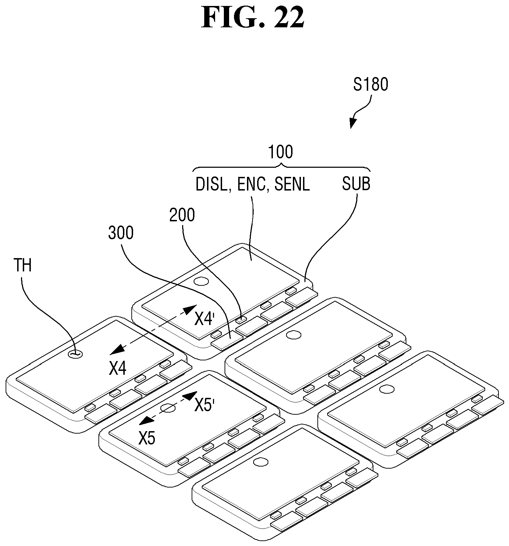

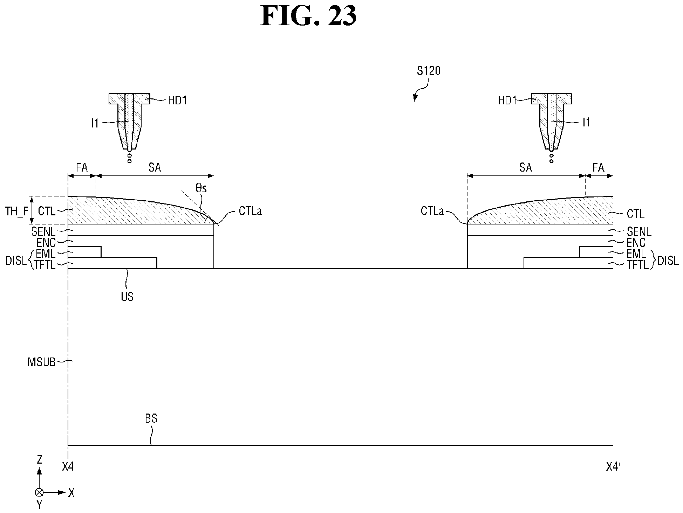

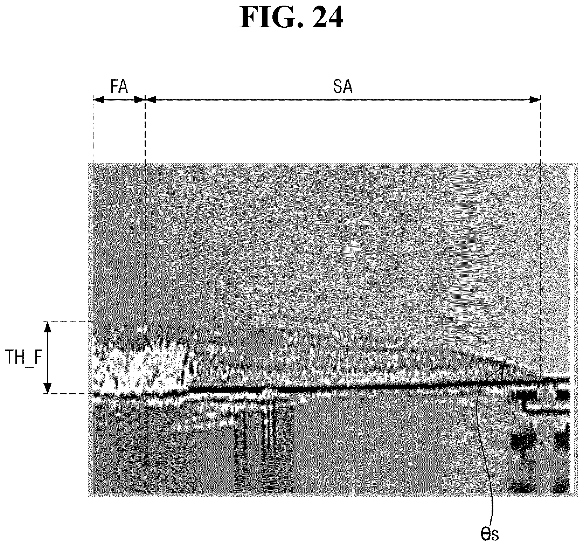

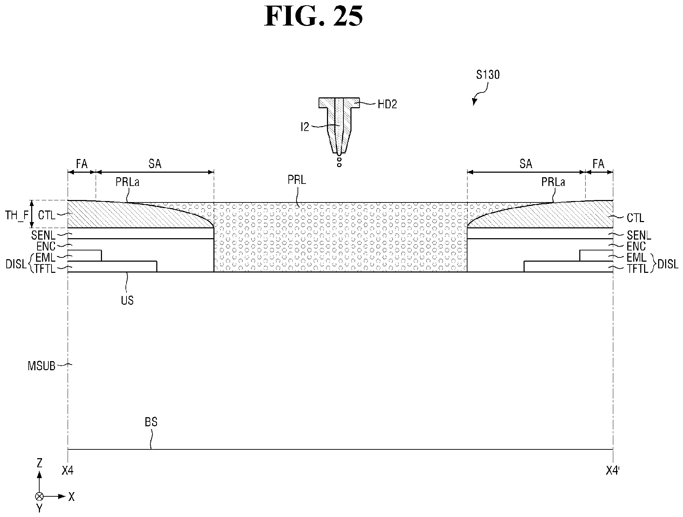

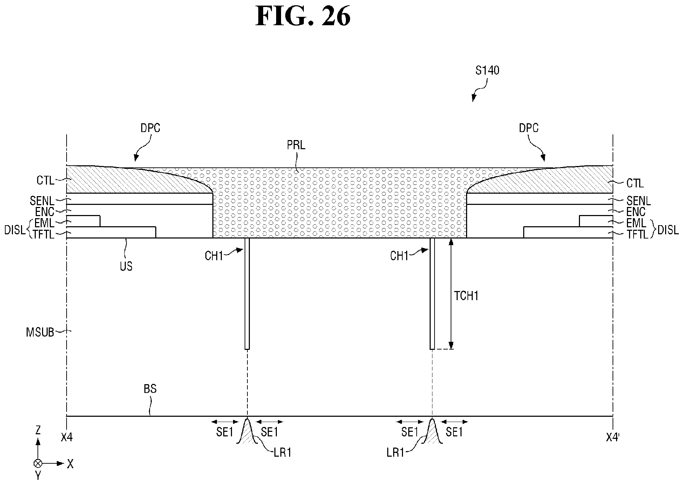

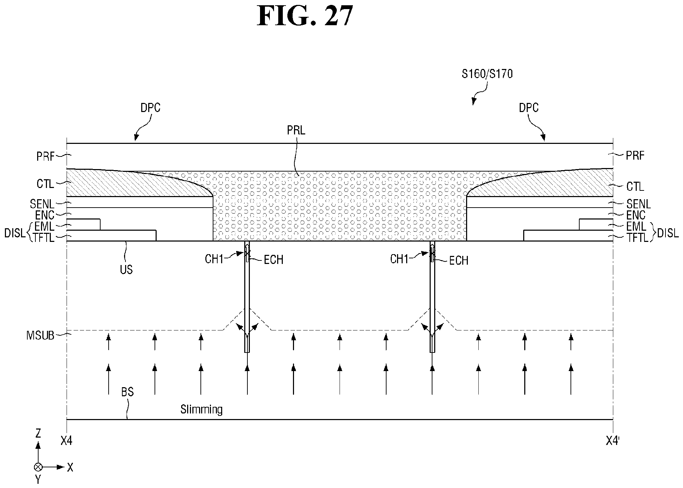

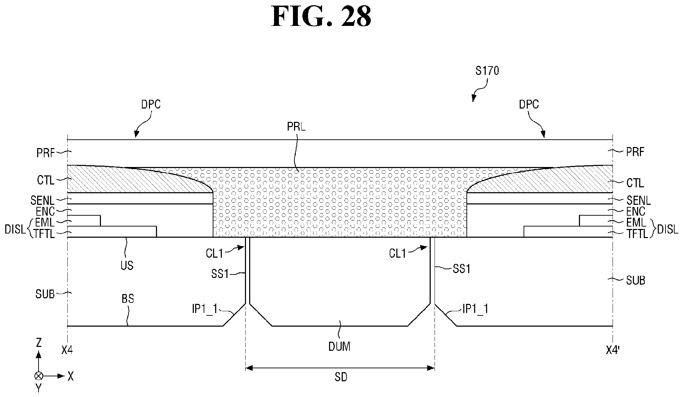

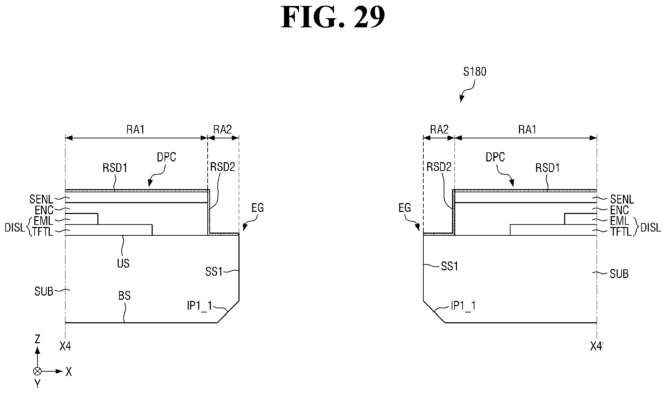

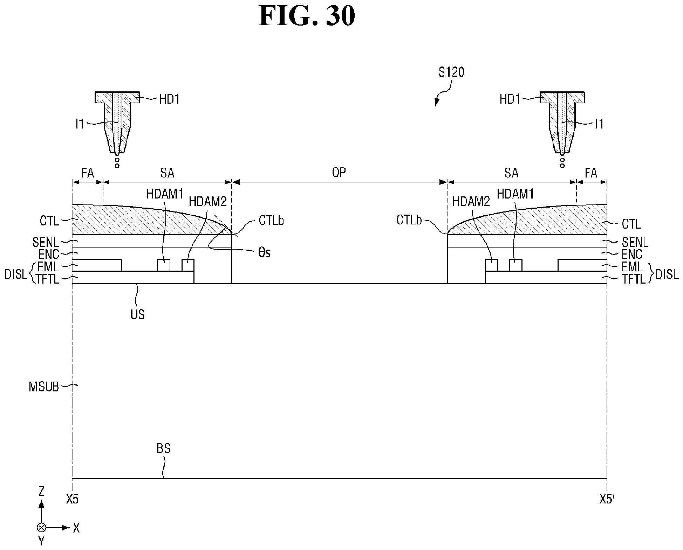

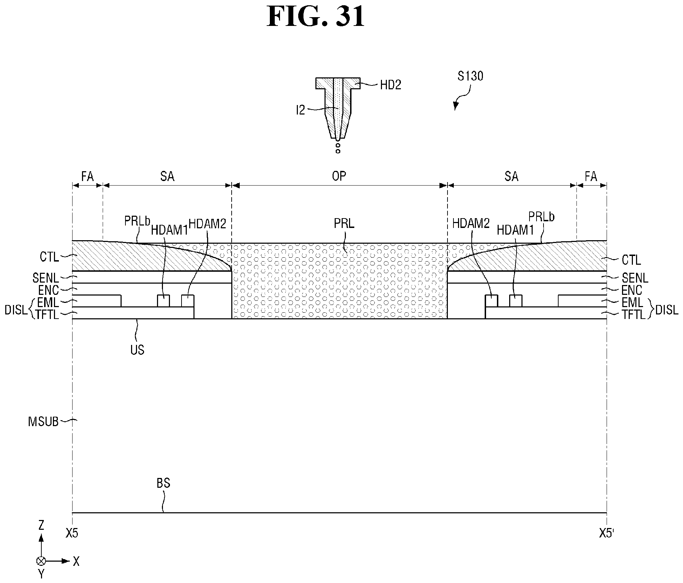

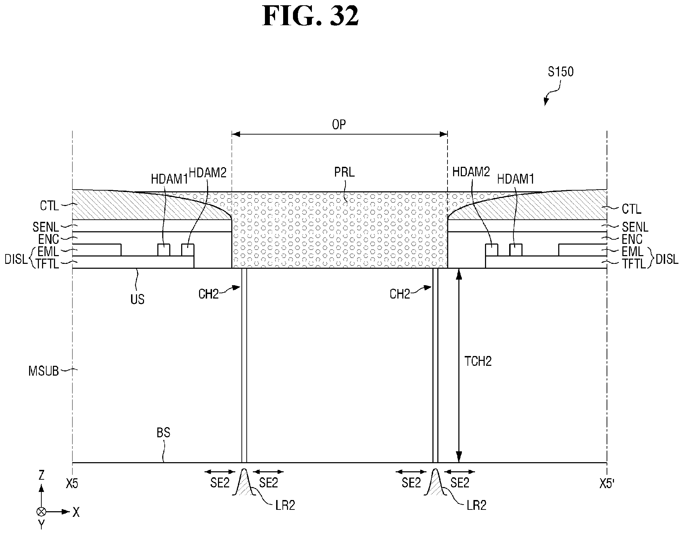

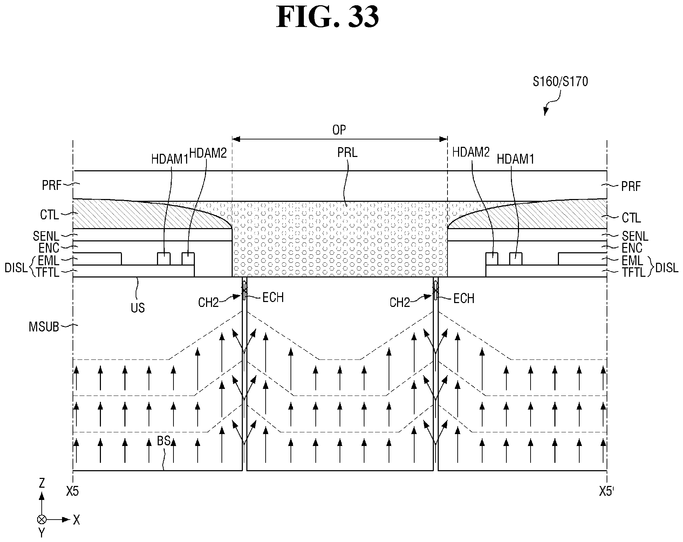

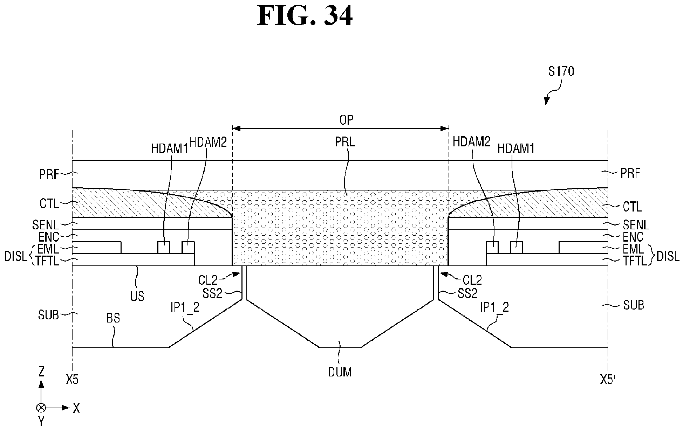

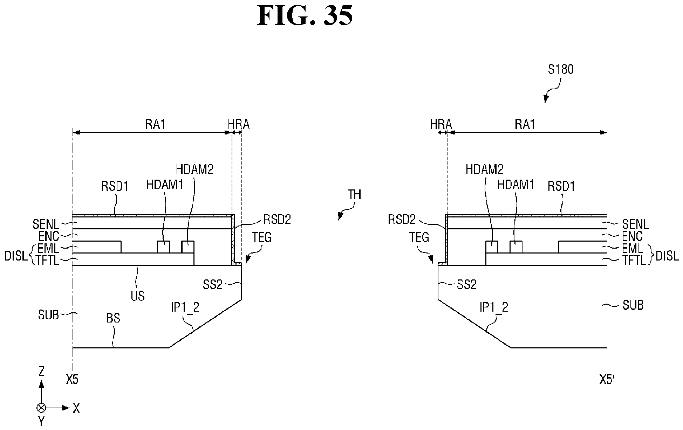

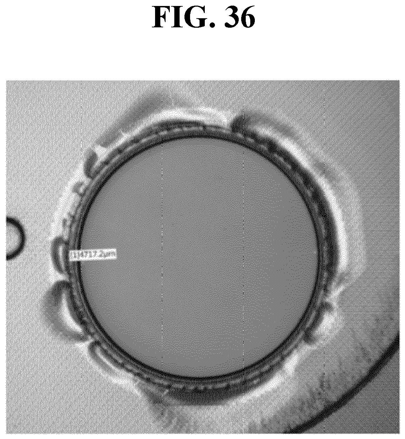

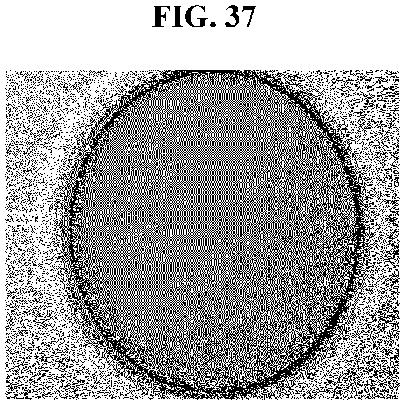

FIG. 13 is a flowchart showing a method for manufacturing a display device according to one or more embodiments. FIG. 14 is a diagram illustrating the depth of a laser irradiation area formed by a laser processing device according to one or more embodiments. FIG. 15 is a perspective view showing S110 of FIG. 13. FIG. 16 is a perspective view showing S120 of FIG. 13. FIG. 17 is a perspective view showing S130 of FIG. 13. FIG. 18 is a perspective view showing S140 of FIG. 13. FIG. 19 is a perspective view showing S150 of FIG. 13. FIG. 20 is a perspective view showing S170 of FIG. 13. FIG. 21 is a plan view showing S170 of FIG. 13. FIG. 22 is a perspective view showing S180 of FIG. 13. FIG. 23 is a cross-sectional view showing S120 of FIG. 13. FIG. 24 is a cross-sectional view showing a coating layer according to one or more embodiments. FIG. 25 is a cross-sectional view showing S130 of FIG. 13. FIG. 26 is a cross-sectional view showing S140 of FIG. 13. FIGS. 27 and 28 are cross-sectional views showing S160 and S170 of FIG. 13. FIG. 29 is a cross-sectional view showing S180 of FIG. 13. FIG. 30 is a cross-sectional view showing S120 of FIG. 13. FIG. 31 is a cross-sectional view showing S130 of FIG. 13. FIG. 32 is a cross-sectional view showing S150 of FIG. 13. FIGS. 33 and 34 are cross-sectional views showing S160 and S170 of FIG. 13. FIG. 35 is a cross-sectional view showing S180 of FIG. 13. FIG. 36 is a photograph showing a through hole and the vicinity thereof according to a conventional embodiment. FIG. 37 is a photograph showing a through hole and the vicinity thereof according to one or more embodiments.

Referring to FIGS. 13 - 37, in the manufacturing method S1 for a display device according to one or more embodiments, firstly, as shown in FIG. 15, a plurality of display cells DPC are formed on a first surface of a mother substrate MSUB (S110 in FIG. 13).

Secondly, as shown in FIGS. 16, 23, 24, and 30, the coating layer CTL is formed on the plurality of display cells DPC, and the plurality of display cells DPC are inspected (S120 in FIG. 13).

First, the coating layer CTL may be formed to cover the plurality of display cells DPC.

As shown in FIG. 16, the coating layer CTL may be disposed on the display cell DPC. The coating layer CTL may cover the top surface of the display cell DPC. The coating layer CTL may include the opening OP exposing at least a part of the display cell DPC. In one or more embodiments, the coating layer CTL (e.g., the area of the coating layer CTL) may be smaller than the display cell DPC in a plan view, but is not limited thereto.

An outer boundary CTLa of the coating layer CTL may be disposed adjacent to the edge or the perimeter of the display cell DPC. The shape of the outer boundary CTLa of the coating layer CTL may conform to the shape of the perimeter of the display cell DPC. In one or more embodiments, the outer boundary CTLa of the coating layer CTL may be positioned inward from the perimeter of the display cell DPC, but is not limited thereto.

An inner boundary CTLb of the coating layer CTL may be the periphery or the circumference of the opening OP of the coating layer CTL. The shape of the inner boundary CTLb of the coating layer CTL may conform to the shape of the opening OP. The shape of the inner boundary CTLb of the coating layer CTL may conform to the shape of the through hole TH to be described later. In one or more embodiments, the inner boundary CTLb of the coating layer CTL may be positioned outside the through hole TH, but is not limited thereto.

In one or more embodiments, the coating layer CTL may be formed by an inkjet printing process. For example, the coating layer CTL may be formed by curing first ink I1 coated on the display cell DPC by a first inkjet head HD1. However, the present disclosure is not limited thereto, and the coating layer CTL may be formed by a coating process such as screen printing and/or dispenser. The coating layer CTL may be cured through at least one of ultraviolet curing, thermal curing, and/or natural curing.

In one or more embodiments, the coating layer CTL may include acrylic resin. For example, the coating layer CTL may be formed by curing the first ink I1 containing acrylic resin, but is not limited thereto.

In some embodiments, the coating layer CTL may include a material having acid resistance to protect the display cell DPC in an etching process to be described later. For example, the coating layer CTL may include at least one of epoxy resin and/or urethane resin. The coating layer CTL may selectively include at least one of acrylic resin, epoxy resin, and/or urethane resin.

As shown in FIGS. 23, 24, and 30, the coating layer CTL may include a flat portion FA and an inclined portion SA.

The flat portion FA may occupy most of the area of the coating layer CTL. The top surface of the coating layer CTL may be flat in the flat portion FA. The thickness of the coating layer CTL in the flat portion FA may be generally constant. Here, the thickness of the coating layer CTL being constant means that a difference in the thickness of the coating layer CTL is approximately ±6% of an average thickness. For example, a difference between a thickness TH_F of the flat portion FA and the average thickness of the entire coating layer CTL may be within about 6% of the average thickness of the entire coating layer CTL. In one or more embodiments, the average thickness of the entire coating layer CTL may be in the range of about 40 µm to about 150 µm, but is not limited thereto.

The inclined portion SA may be disposed adjacent to the perimeter of the display cell DPC and the opening OP of the coating layer CTL. In the inclined portion SA, the top surface of the coating layer CTL may be an inclined surface. The inclined surface may be of a curved shape in cross-sectional view, but is not limited thereto, and may be linear.

In the inclined portion SA, the thickness of the coating layer CTL may decrease as it approaches the perimeter of the display cell DPC, and may decrease as it approaches the opening OP of the coating layer CTL. In the inclined portion SA, the thickness of the coating layer CTL may increase as it approaches the flat portion FA.

An angle θs of the tangent line of the inclined portion SA at the outer boundary CTLa and the inner boundary CTLb of the coating layer CTL may be within about 30 degrees. In one or more embodiments, the angle θs of the tangent line of the inclined portion SA at the outer boundary CTLa and the inner boundary CTLb of the coating layer CTL may be within about 15 degrees.

Because the manufacturing method S1 for a display device according to the present embodiment includes forming the coating layer CTL, the process efficiency and the process yield may be improved.

The conventional embodiment may include a cutting process of attaching a protective film onto the entire surface of the mother substrate MSUB instead of the coating layer CTL and removing a part of the protective film according to the size of the display cell DPC. In addition, the conventional embodiment may include a cutting process of removing a part of the protective film to form an opening such as the opening OP of the coating layer CTL. A laser process may be mainly used to remove a part of the protective film. As shown in FIG. 36, as an adhesive of the protective film is carbonized by laser, a carbonized foreign material may be generated at the cut portion, which may cause poor adhesion of a layer thereunder. In an etching process to be described later, an etchant may permeate between the layers that are attached poorly, which may cause corrosion and damage of the display cell DPC

In the manufacturing method S1 for the display device according to the present embodiment, because the coating layer CTL having a required shape can be formed through a printing process, the cutting process as in the conventional embodiment may be omitted. Therefore, as shown in FIG. 37, problems such as carbonized foreign matter, poor adhesion of a layer, and etchant permeation do not occur, so the process efficiency and the process yield may be improved.

After forming the coating layer CTL, the plurality of display cells DPC are inspected using an inspection device. After connecting a probe to a plurality of test pads provided on each of the plurality of display cells DPC, a lighting test of each of the plurality of display cells DPC may be performed.

When the lighting test is performed after separating the plurality of display cells DPC from the mother substrate MSUB by the cutting process, an additional process for removing the plurality of test pads is required after completing the lighting test. On the other hand, when the lighting test is performed on the mother substrate MSUB, the plurality of test pads are removed when the plurality of display cells DPC are separated from the mother substrate MSUB through laser irradiation and etching later. Accordingly, when the lighting test is performed on the mother substrate MSUB, there is an advantage in that no additional process for removing the plurality of test pads is required.

Because the coating layer CTL is disposed to overlap the display areas of the display cells DPC, it may have a higher light transmittance than that of the acid resistant layer PRL, which will be described later, for performing a lighting test. Accordingly, the accuracy of the display cell DPC inspection process may be improved.

Thirdly, as shown in FIGS. 17, 25, and 31, the acid resistant layer PRL is formed between the plurality of display cells DPC and in the opening OP of the coating layer CTL (S130 in FIG. 13).

The acid resistant layer PRL may be formed between the display cells DPC and in the opening OP of the coating layer CTL.

As shown in FIG. 17, the acid resistant layer PRL may be disposed between the display cells DPC and in the opening OP of the coating layer CTL. The acid resistant layer PRL may partially cover the top surfaces of the display cells DPC and the coating layer CTL along the edges of the coating layer CTL and the display cells DPC.

The acid resistant layer PRL may be in direct contact with the top surface US of the mother substrate MSUB, the side surface of the display cell DPC, and the top surface of the coating layer CTL. In one or more embodiments, when the outer boundary CTLa of the coating layer CTL is located inward from the outer boundary of the display cell DPC such that the coating layer CTL partially exposes the top surface of the display cell DPC, the acid resistant layer PRL may also be in direct contact with the exposed top surface of the display cell DPC.

The acid resistant layer PRL may include an outer boundary PRLa and an inner boundary PRLb. The outer boundary PRLa of the acid resistant layer PRL may be a boundary portion located adjacent to the perimeter of the display cell DPC and the outer boundary CTLa of the coating layer CTL. The inner boundary PRLb of the acid resistant layer PRL may be a boundary portion located adjacent to the opening OP of the coating layer CTL or the inner boundary CTLb of the coating layer CTL.

The outer boundary PRLa of the acid resistant layer PRL may be disposed adjacent to the perimeter of the display cell DPC. The shape of the outer boundary PRLa of the acid resistant layer PRL may correspond to the peripheral shape of the display cell DPC. In one or more embodiments, the outer boundary PRLa of the acid resistant layer PRL may be located inward from the perimeter of the display cell DPC.

The outer boundary PRLa of the acid resistant layer PRL may be located inward from the outer boundary CTLa of the coating layer CTL. Accordingly, an overlapping area where the acid resistant layer PRL overlaps the coating layer CTL may be formed between the outer boundary PRLa of the acid resistant layer PRL and the outer boundary CTLa of the coating layer CTL.

The inner boundary PRLb of the acid resistant layer PRL may be disposed adjacent to the opening OP of the coating layer CTL. The shape of the inner boundary PRLb of the acid resistant layer PRL may correspond to the shape of the opening OP of the coating layer CTL. In one or more embodiments, the inner boundary PRLb of the acid resistant layer PRL may be located outward from the opening OP of the coating layer CTL.

In one or more embodiments, the acid resistant layer PRL may be formed by an inkjet printing, dispenser printing, screen printing, and/or slit coating process. For example, the acid resistant layer PRL may be formed by applying second ink I2 between the display cells DPC and into the opening OP of the coating layer CTL by a second inkjet head HD2 and curing it. The acid resistant layer PRL may be cured through ultraviolet curing, heat curing, and/or natural curing.

The acid resistant layer PRL may include acrylic resin, polyethylene resin, polyvinyl chloride resin, thiol resin, epoxy resin, and/or silicone resin.

The acid resistant layer PRL may include a material having acid resistance to prevent permeation of an etchant ECH along a plurality of first laser irradiation areas CH1 and a plurality of second laser irradiation areas CH2 in the etching process to be described later. For example, the acid resistant layer PRL may include at least one fluoropolymer of polytetrafluoroethylene (PTFE) and/or polyvinylidene fluoride.

In one or more embodiments, the acid resistant layer PRL may have higher acid resistance than that of the coating layer CTL. For example, because the acid resistant layer PRL is in direct contact with the mother substrate MSUB, it may primarily directly prevent permeation of the etchant ECH in the etching process to be described later. Accordingly, the acid resistant layer PRL may have higher acid resistance than that of the coating layer CTL.

The acid resistant layer PRL may include a first portion that overlaps the coating layer CTL in the third direction (Z-axis direction) and a second portion that does not overlap the coating layer CTL in the third direction (Z-axis direction). The first portion may be in direct contact with the top surface of the coating layer CTL. The second portion may be in direct contact with the side and top surface of the display cell DPC and the top surface of the mother substrate MSUB.

In the manufacturing method S1 (see FIG. 13) for a display device according to the present embodiment, the acid resistant layer PRL is disposed, so that permeation of the etchant ECH may be reduced or minimized. Accordingly, the widths of the edge area EGA (see FIG. 6) and the through hole edge area TEGA (see FIG. 10) of the display device 10 may be reduced or minimized, and the width of the non-display area NDA of the display device 10 may be reduced or minimized.

For example, the acid resistant layer PRL may fill the space between the display cells DPC and the opening OP of the coating layer CTL. Accordingly, the space between the mother substrate MSUB and a protective film PRF, which will be described later, may be filled. As the acid resistant layer PRL fills the empty space on the mother substrate MSUB, the etchant ECH may be prevented from permeating into the display cell DPC. Accordingly, the widths of the edge area EGA (see FIG. 6) and the through hole edge area TEGA (see FIG. 10) of the display device 10 may be reduced or minimized, and the width of the non-display area NDA of the display device 10 may be reduced or minimized.

Fourthly, as shown in FIGS. 18 and 26, a first laser LR1 is irradiated onto a second surface opposite to a first surface of the mother substrate MSUB, thereby forming the plurality of first laser irradiation areas CH1 disposed along the edges of the plurality of display cells DPC (S140 in FIG. 13).

Although various types of lasers may be used as the first laser LR1 according to one or more embodiments, the present disclosure shows as an example that the first laser LR1 is an infrared Bessel beam having a wavelength of approximately 1030 nm.

As illustrated in FIGS. 18 and 26, the first laser LR1 may be irradiated onto the second surface of the mother substrate MSUB. However, the present disclosure is not limited thereto. The first laser LR1 may be irradiated onto the first surface of the mother substrate MSUB.

A first sketch line LS1 may be defined as an imaginary line connecting the plurality of first laser irradiation areas CH1. The first sketch line LS1 may be formed by irradiating the first laser LR1 to form the plurality of first laser irradiation areas CH1 along edges of the plurality of display cells DPC.

A one-side tolerance SE1 of the first laser LR1 may be within approximately 50 µm, and the both-sides tolerance of the first laser LR1 may be within approximately 100 µm. The one-side tolerance SE1 of the first laser LR1 may be a cutting error in one direction (e.g., the X-axis direction) when the plurality of first laser irradiation areas CH1 are formed by the first laser LR1.

Fifthly, as illustrated in FIGS. 19 and 32, the plurality of second laser irradiation areas CH2 for forming the through hole TH in each of a plurality of display cells are formed by irradiating second laser LR2 onto the second surface of the mother substrate MSUB (S150 in FIG. 13).

Although FIG. 13 illustrates that S150 is performed after S140 is performed, the present disclosure is not limited thereto. In order to reduce the process time, S140 and S150 may be performed concurrently (e.g., simultaneously) by providing a plurality of laser processing devices LD1 and LD2. Alternatively, S140 may be performed after S150.

Although various types of lasers may be used as the second laser LR2 according to one or more embodiments, the present disclosure shows as an example that the second laser LR2 is an infrared Bessel beam having a wavelength of approximately 1030 nm.

As illustrated in FIGS. 19 and 32, the second laser LR2 may be irradiated onto the second surface of the mother substrate MSUB. However, the present disclosure is not limited thereto. The second laser LR2 may be irradiated onto the first surface of the mother substrate MSUB.

A second sketch line LS2 may be defined as an imaginary line connecting the plurality of second laser irradiation areas CH2. The second sketch line LS2 may be formed by irradiating the second laser LR2 to form the plurality of second laser irradiation areas CH2 along the edge of the through hole TH. The second sketch line LS2 may depend on the shape of the through hole TH. For example, when the through hole TH has a circular planar shape, the second sketch line LS2 may be formed in a circular shape.

A one-side tolerance SE2 of the second laser LR2 may be within approximately 50 µm, and the both-sides tolerance of the second laser LR2 may be within approximately 100 µm. The one-side tolerance SE2 of the second laser LR2 may be a cutting error in one direction (e.g., the X-axis direction) when the plurality of second laser irradiation areas CH2 are formed by the second laser LR2.

When the first laser LR1 and the second laser LR2 are irradiated onto the second surface of the mother substrate MSUB, as illustrated in FIG. 14, a depth TCH1 (or a sketch length) of each of the plurality of first laser irradiation areas CH1 and a depth TCH2 (or a sketch length) of each of the plurality of second laser irradiation areas CH2 may be adjusted according to a repetition rate, a processing speed, and/or pulse energy.

For example, the depth TCH1 of each of the plurality of first laser irradiation areas CH1 may be approximately 50 µm from the first surface of the mother substrate MSUB as illustrated in (a) of FIG. 14. In addition, because the thickness of the mother substrate MSUB is approximately 500 µm, the depth TCH2 of each of the plurality of second laser irradiation areas CH2 may be approximately 500 µm. That is, the depth TCH2 of each of the plurality of second laser irradiation areas CH2 may be approximately 50 µm to 500 µm from the first surface of the mother substrate MSUB.

The first laser LR1 for forming the first laser irradiation areas CH1 may be irradiated with a repetition rate of 10 kHz to 250 kHz, a processing speed of 10 mm/s to 250 mm/s, and pulse energy of 10 µJ to 300 µJ. However, in order for the first laser LR1 to have a depth of approximately 225 µm from the first surface of the mother substrate MSUB, it is desirable to perform irradiation with a repetition rate of approximately 17.5 kHz to 125 kHz, a processing speed of 17.5 mm/s to 125 mm/s, and pulse energy of 25 µJ to 178 µJ.

The second laser LR2 for forming the second laser irradiation areas CH2 may be irradiated with a repetition rate of 1 kHz to 50 kHz, a processing speed of 1 mm/s to 50 mm/s, and pulse energy of 10 µJ to 300 µJ. However, in order for the second laser LR2 to have a depth of approximately 400 µm to 500 µm from the first surface of the mother substrate MSUB, irradiation may be performed with a repetition rate of approximately 10 kHz, a processing speed of 10 mm/s, and pulse energy of 60 µJ to 178 µJ. In particular, while the second laser LR2 forms the circular second sketch line LS2, the first laser LR1 forms the first sketch line LS1 along the edge of each of the plurality of display cells DPC, so that the processing speed of the second laser LR2 may be slower than the processing speed of the first laser LR1.

Sixthly, as shown in FIGS. 27 and 33, the protective film PRF is attached onto the coating layer CTL and the acid resistant layer PRL (S160 in FIG. 13).

The protective film PRF may be attached onto the entire first surface of the mother substrate MSUB. For example, the protective film PRF may be attached onto the coating layer CTL and the acid resistant layer PRL.

The protective film PRF may be an acid-resistant film to protect the plurality of display cells DPC from an etchant in an etching process for the mother substrate MSUB to be carried out in the next step. For example, the protective film PRF may include polyethylene terephthalate (PET), polypropylene (PP), polycarbonate (PC), polyethylene (PE), and/or polyvinyl chloride (PVC).

In one or more embodiments, the protective film PRF may include an adhesive layer thereunder. The adhesive layer may include silicon-based, polyurethane-based, and/or acrylic-based materials, but is not limited thereto.

Seventhly, as illustrated in FIGS. 20, 21, 27, 28, 33, and 34, the etchant is sprayed on the second surface of the mother substrate MSUB without a separate mask to reduce the thickness of the mother substrate MSUB, while the mother substrate is cut along the plurality of first laser irradiation areas CH1 and the plurality of second laser irradiation areas CH2 (S170 in FIG. 13).

When the etchant is sprayed on the second surface of the mother substrate MSUB, the mother substrate MSUB may be reduced from the first thickness TH1 to the second thickness TH2. Because the mother substrate MSUB is etched without a separate mask, isotropic etching in which the mother substrate MSUB is uniformly etched over the entire area of the second surface may be performed.

Each of the plurality of first laser irradiation areas CH1 may include a physical hole formed by the first laser LR1 and an area around the physical hole of which physical properties are changed by the laser. Alternatively, each of the plurality of first laser irradiation areas CH1 may be an area of which physical properties are changed by the first laser LR1 without a physical hole. Accordingly, the etching rate in each of the plurality of first laser irradiation areas CH1 by the etchant may be higher than the etching rate in other areas of the mother substrate MSUB to which the laser is not irradiated.

When the thickness of the mother substrate MSUB is reduced by the etchant and the etchant permeates into the plurality of first laser irradiation areas CH1 formed by the first laser LR1, due to the plurality of first laser irradiation areas CH1, a difference may occur in etching rates between an area in which the first laser irradiation areas CH1 are formed and an area in which the first laser irradiation areas CH1 are not formed. That is, the mother substrate MSUB may be performed with anisotropic etching in which the etching rate in the area in which the first laser irradiation areas CH1 are formed is faster than the etching rate in the area in which the first laser irradiation areas CH1 are not formed. Accordingly, as illustrated in FIG. 29, the substrate SUB separated from the mother substrate MSUB may include the first inclined surface IP1_1 disposed between the first side surface SS1 and the bottom surface BS.

In addition, as the etchant permeates into the plurality of first laser irradiation areas CH1 formed by the first laser LR1, the mother substrate MUSB may be separated along a first cutting line CL1 (e.g., see FIG. 28). That is, each of the plurality of display cells DPC may be separated from the mother substrate MSUB. The first cutting line CL1 may be formed along the first sketch line LS1.

In one or more embodiments, as shown in FIG. 21, the outer boundary CTLa of the coating layer CTL may be located inward from the first cutting line CL1, and the outer boundary PRLa of the acid resistant layer PRL may be located inward from the first cutting line CL1. In one or more embodiments, the outer boundary CTLa of the coating layer CTL may be located between the outer boundary PRLa of the acid resistant layer PRL and the first cutting line CL1. Accordingly, an overlapping area of the acid resistant layer PRL and the coating layer CTL may be formed between the outer boundary PRLa of the acid resistant layer PRL and the outer boundary CTLa of the coating layer CTL.

In one or more embodiments, the one-side tolerance of the laser may be approximately 50 µm, and the width of the first laser irradiation area CH1 formed by the first laser LR1 may be expanded by approximately 40 µm by the etchant. Accordingly, considering the both-sides tolerance of the laser of each of the display cells DPC and the width of the first laser irradiation area CH1 expanded by the etchant, a separation distance SD (e.g., see FIG. 28) between the display cells DPC adjacent to each other may be approximately 280 µm, but is not limited thereto. A dummy DUM, which is a part of the mother substrate MSUB remaining after cutting, may be formed between the neighboring display cells DPC.

Each of the plurality of second laser irradiation areas CH2 may include a physical hole formed by the second laser LR2 and an area around the physical hole of which physical properties are changed by the laser. Alternatively, each of the plurality of second laser irradiation areas CH2 may be an area of which physical properties are changed by the second laser LR2 without a physical hole. Accordingly, the etching rate in each of the plurality of second laser irradiation areas CH2 by the etchant may be higher than the etching rate in other areas of the mother substrate MSUB to which the laser is not irradiated.

Due to the anisotropic etching, as illustrated in FIG. 35, the substrate SUB separated from the mother substrate MSUB may include the second inclined surface IP1_2 disposed between the bottom surface BS and the second side surface SS2 of the edge TEG of the through hole TH.

In addition, as the etchant permeates into the plurality of second laser irradiation areas CH2 formed by the second laser LR2, the mother substrate MUSB may be separated along a second cutting line CL2 to form the through hole TH. The second cutting line CL2 may be formed along the second sketch line LS2.

In one or more embodiments, as shown in FIG. 21, the inner boundary CTLb of the coating layer CTL may be located outward from the second cutting line CL2, and the inner boundary PRLb of the acid resistant layer PRL may be located outward from the second cutting line CL2. Meanwhile, the inner boundary CTLb of the coating layer CTL may be located between the inner boundary PRLb of the acid resistant layer PRL and the second cutting line CL2. Accordingly, an overlapping area of the acid resistant layer PRL and the coating layer CTL may be formed between the inner boundary PRLb of the acid resistant layer PRL and the inner boundary CTLb of the coating layer CTL.

As illustrated in FIGS. 27 and 33, because the depth of each of the plurality of second laser irradiation areas CH2 is deeper than the depth of each of the plurality of first laser irradiation areas CH1, the etchant may permeate into the plurality of second laser irradiation areas CH2 earlier than the plurality of first laser irradiation areas CH1. That is, because the plurality of second laser irradiation areas CH2 are etched along with a slimming process in which the thickness of the mother substrate MSUB is reduced by the etchant, the substrate SUB forms a tapered cross section by isotropic etching in the through hole TH formed by the second laser irradiation area CH2. In comparison, the plurality of first laser irradiation areas CH1 are not etched when slimming is performed. Accordingly, a difference may occur between the length and angle of the inclination direction of the first inclined surface IP1_1 in the edge of the substrate SUB formed by the plurality of first laser irradiation areas CH1, and the length and angle of the inclined direction of the second inclined surface IP1_2 in the through hole TH formed by the plurality of second laser irradiation areas CH2.

The dummy DUM, which is a part of the mother substrate MSUB remaining after cutting, may be formed in an area overlapping the opening OP of the coating layer CTL.

Eighthly, as shown in FIGS. 22, 29, and 35, the protective film PRF is detached, the driving IC 200 and the circuit board 300 are attached to each of the display cells DPC, and the coating layer CTL is detached from each of the display cells DPC (S180 in FIG. 13).

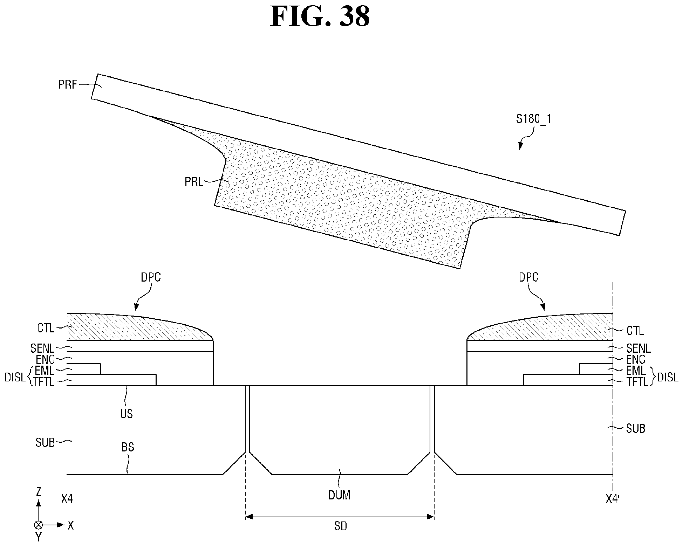

After the etching process is completed, the protective film PRF may be detached. The acid resistant layer PRL, the coating layer CTL, and the dummy DUM may be removed together with the protective film PRF or after detachment of the protective film PRF. Various methods for removing the protective film PRF, the acid resistant layer PRL, the coating layer CTL, and the dummy DUM will be described later with reference to FIGS. 38 - 47.

Through the etching process, each of the plurality of display cells DPC may be separated from the mother substrate MSUB, and the through hole TH may be formed in each of the plurality of display cells DPC.

In one or more embodiments, when detaching the coating layer CTL, the adhesive force of the coating layer CTL may be different in the inclined portion SA and the flat portion FA. The adhesive force of the coating layer CTL in the inclined portion SA may be in the range of about 10 gf/inch to about 150 gf/inch, and the adhesive force of the coating layer CTL in the flat portion FA may be in the range of about 5 gf/inch to about 10 gf/inch.

After the coating layer CTL is removed, the first residue trace RSD1 may be formed on the top surface of the display cell DPC. After the acid resistant layer PRL is removed, the second residue trace RSD2 may be formed on the side surface of the display cell DPC. In one or more embodiments, the acid resistant layer PRL may also be formed on the top surface of the display cell DPC.

As described above, by using the laser and the etching process, the thickness of the substrate SUB may be reduced, the substrate SUB of each of the plurality of display cells DPC may be separated from the mother substrate MSUB, and at the same time (e.g., concurrently) the through hole TH may be formed, so that the efficiency of the manufacturing process may be increased.

Hereinafter, other embodiments of S180 according to one or more embodiments will be described. In the following embodiments, description of the same components as those of the above-described embodiment, which are denoted by like reference numerals, will be omitted or simplified, and differences will be mainly described.

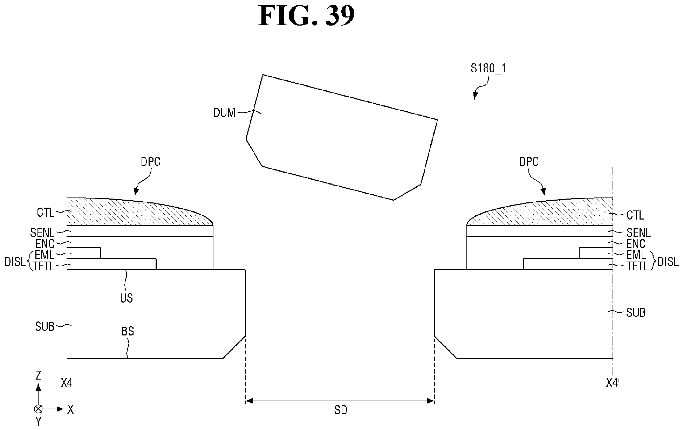

FIGS. 38 and 39 are cross-sectional views showing S180_1 according to one embodiment.

Referring to FIGS. 38 and 39, after the etching process is completed, the protective film PRF, the acid resistant layer PRL, the coating layer CTL, and the dummy DUM may be removed.

In one or more embodiments, as shown in FIG. 38, the protective film PRF and the acid resistant layer PRL may be removed concurrently (e.g., simultaneously). Thereafter, as shown in FIG. 39, the dummy DUM may be removed. Then, the coating layer CTL may be removed. Alternatively, after removing the protective film PRF and the acid resistant layer PRL, the coating layer CTL and the dummy DUM may be removed in that order.

In the present disclosure, the adhesive force between the protective film PRF and the acid resistant layer PRL may be greater than the adhesive force between the protective film PRF and the coating layer CTL, the adhesive force between the acid resistant layer PRL and the coating layer CTL, and the adhesive force between the side surface of the display cell DPC and the acid resistant layer PRL.

Because the adhesive force between the side surface of the display cell DPC and the acid resistant layer PRL is less than the adhesive force between the protective film PRF and the acid resistant layer PRL, it is possible to prevent poor adhesion of the encapsulation layer ENC and the sensor electrode layer SENL included in the display cell DPC.

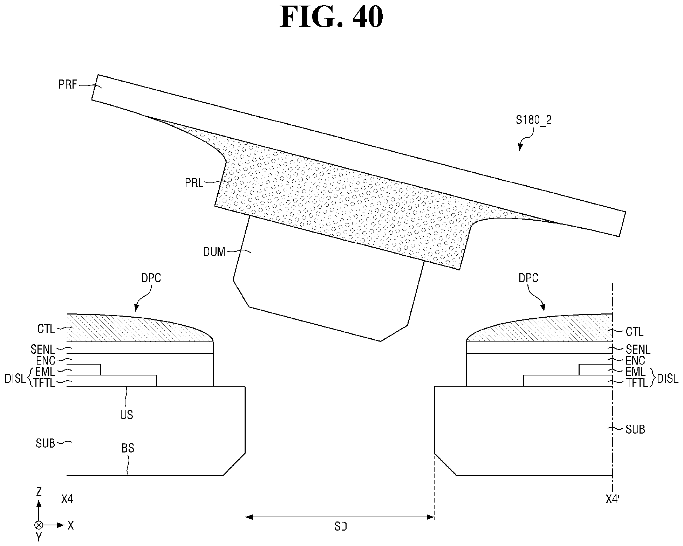

FIG. 40 is a cross-sectional view showing S180_2 according to one or more embodiments.

Referring to FIG. 40, in one or more embodiments, the protective film PRF, the acid resistant layer PRL, and the dummy DUM may be removed concurrently (e.g., simultaneously) as shown in FIG. 40. Subsequently, the coating layer CTL may be removed.

In the present embodiment, the adhesive force between the acid resistant layer PRL and the dummy DUM may be greater than the adhesive force between the protective film PRF and the coating layer CTL, the adhesive force between the acid resistant layer PRL and the coating layer CTL, and the adhesive force between the side surface of the display cell DPC and the acid resistant layer PRL.

Because the dummy DUM is removed concurrently (e.g., simultaneously) with the protective film PRF and/or the like, process efficiency may be improved.

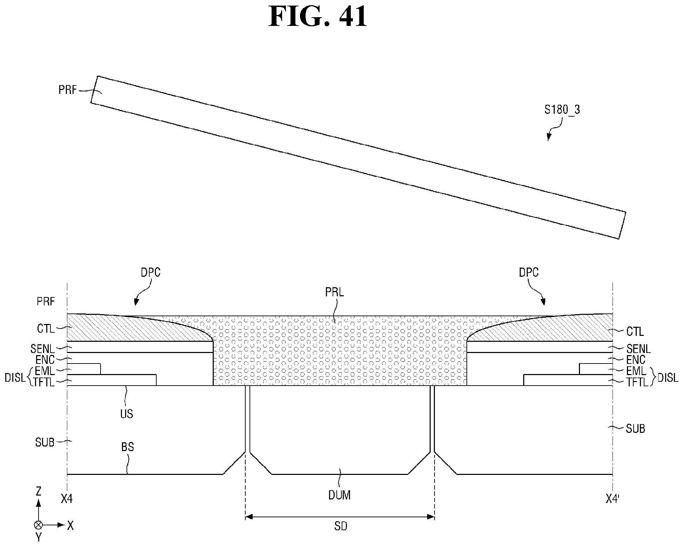

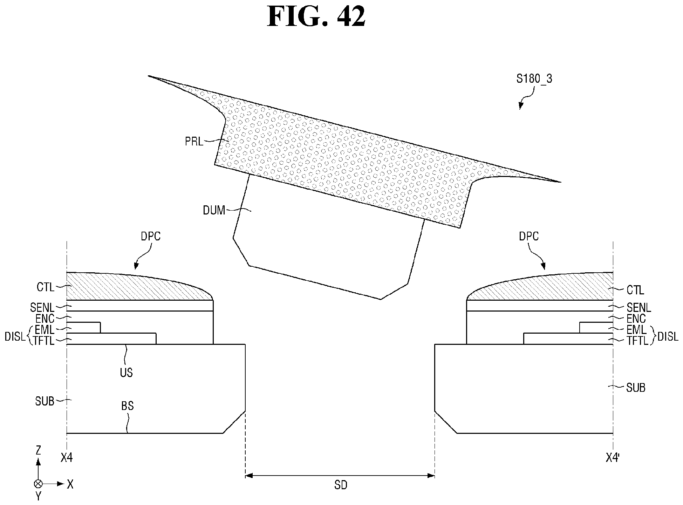

FIGS. 41 and 42 are cross-sectional views showing S180_3 according to one or more embodiments.

Referring to FIGS. 41 and 42, in one or more embodiments, the protective film PRF may be removed first as shown in FIG. 41. Thereafter, as shown in FIG. 42, the acid resistant layer PRL and the dummy DUM may be removed concurrently (e.g., simultaneously). Thereafter, the coating layer CTL may be removed.

In the case of the present embodiment, the adhesive force between the protective film PRF and the coating layer CTL and the adhesive force between the protective film PRF and the acid resistant layer PRL may be less than the adhesive force between the acid resistant layer PRL and the dummy DUM, the adhesive force between the acid resistant layer PRL and the coating layer CTL, and the adhesive force between the side surface of the display cell DPC and the acid resistant layer PRL.

As the protective film PRF is separated from the acid resistant layer PRL and the dummy DUM, the exposure latency of the through hole TH may be reduced or minimized when a separate process is added between the process of removing the protective film PRF and the process of removing the acid resistant layer PRL and the dummy DUM. Accordingly, it is possible to prevent foreign substances from entering the through hole TH.

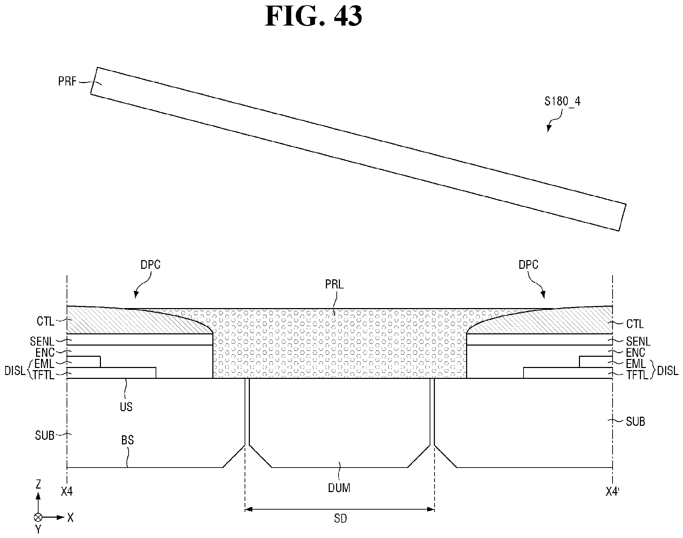

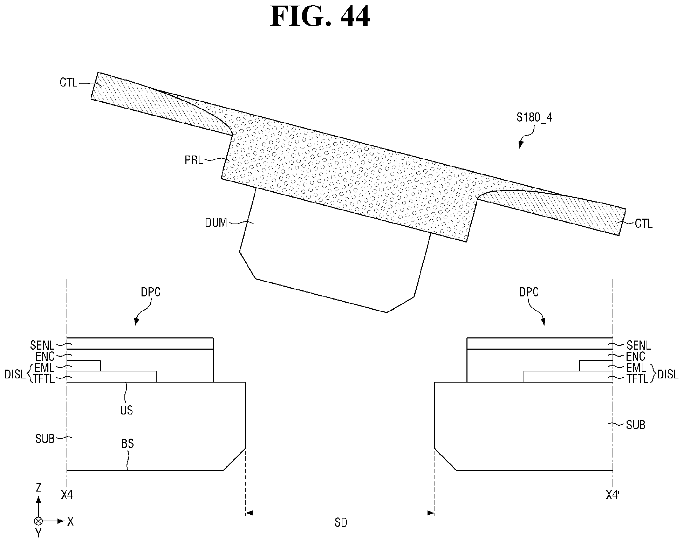

FIGS. 43 and 44 are cross-sectional views showing S180_4 according to one or more embodiments.

Referring to FIGS. 43 and 44, in one or more embodiments, the protective film PRF may be removed first as shown in FIG. 43. Thereafter, as shown in FIG. 44, the acid resistant layer PRL, the dummy DUM, and the coating layer CTL may be removed concurrently (e.g., simultaneously).

In the present embodiment, the adhesive force between the acid resistant layer PRL and the dummy DUM may be greater than the adhesive force between the top surface of the display cell DPC and the coating layer CTL, and the adhesive force between the side surface of the display cell DPC and the acid resistant layer PRL.

When removing the acid resistant layer PRL, the dummy DUM is removed together with the acid resistant layer PRL, so that process efficiency may be improved.

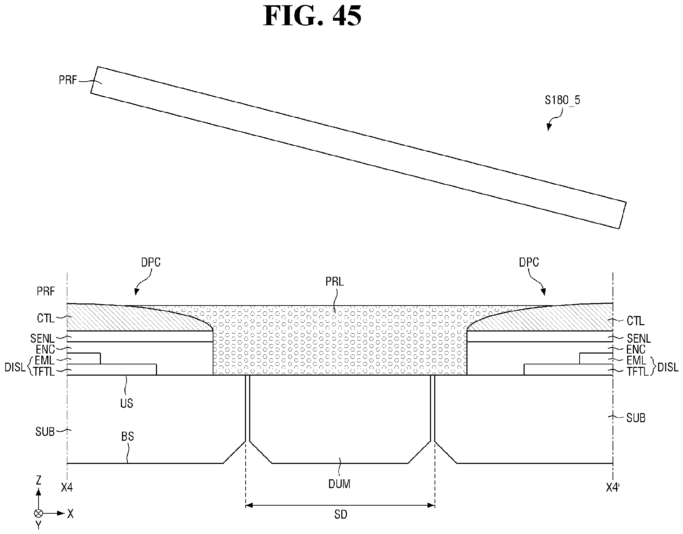

FIGS. 45 - 47 are cross-sectional views showing S180_5 according to one or more embodiments.

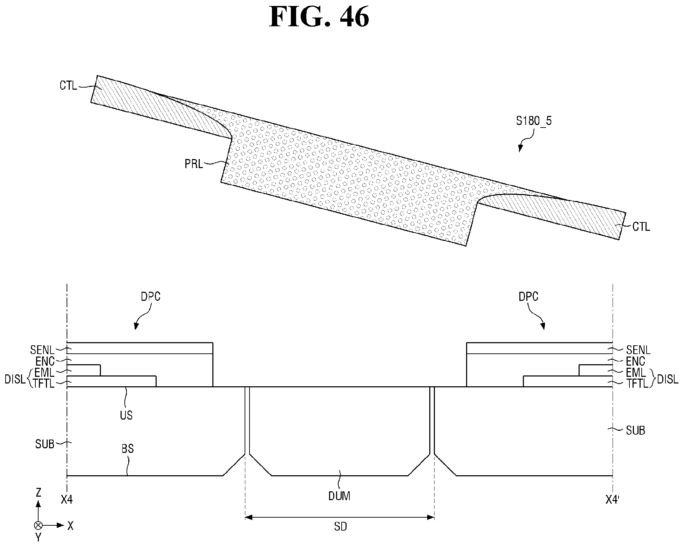

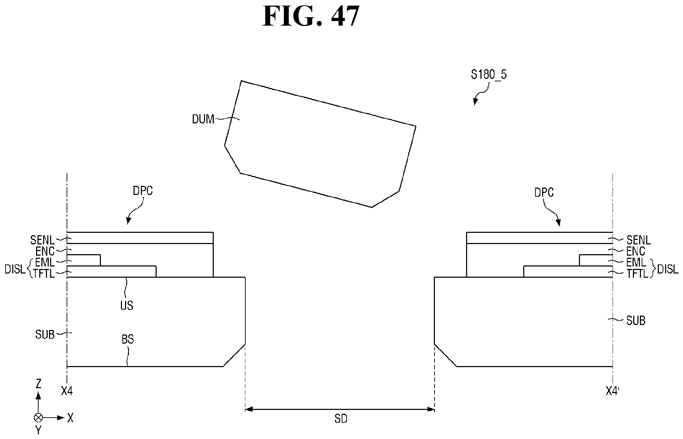

Referring to FIGS. 45 - 47, in one or more embodiments, the protective film PRF may be removed first as shown in FIG. 45. Thereafter, as shown in FIG. 46, the acid resistant layer PRL and the coating layer CTL may be removed simultaneously. Then, as shown in FIG. 47, the dummy DUM may be removed.

In the case of the present embodiment, the adhesive force between the protective film PRF and the coating layer CTL and the adhesive force between the protective film PRF and the acid resistant layer PRL may be less than the adhesive force between the acid resistant layer PRL and the dummy DUM, the adhesive force between the acid resistant layer PRL and the coating layer CTL, and the adhesive force between the side surface of the display cell DPC and the acid resistant layer PRL.

In addition, the adhesive force between the acid resistant layer PRL and the dummy DUM may be less than the adhesive force between the top surface of the display cell DPC and the coating layer CTL and the adhesive force between the side surface of the display cell DPC and the acid resistant layer PRL.

By performing the process of removing the acid resistant layer PRL and the coating layer CTL separately from the process of removing the dummy DUM, the exposure latency of the through hole TH may be reduced or minimized. Accordingly, it is possible to prevent foreign substances from entering the through hole TH.

In concluding the detailed description, those skilled in the art will appreciate that many variations and modifications can be made to the described embodiments without substantially departing from the principles and scope of the present disclosure. Therefore, the described embodiments of the present disclosure are used in a generic and descriptive sense only and not for purposes of limitation.

## Claims

1. A display device comprising:
a display panel comprising at least one conductive layer and at least one non-conductive film on the at least one conductive layer;
a first residue trace on a top surface of the at least one non-conductive film; and
a second residue trace on one side of the first residue trace.

2. The display device of claim 1, wherein:
the first residue trace is on a top surface of the display panel; and
the second residue trace is on a side surface or the top surface of the display panel.

3. The display device of claim 1 or claim 2, wherein:
the second residue trace is adjacent to an edge of the display panel; and
the first residue trace is surrounded by the second residue trace.

4. The display device of any one of claims 1 to 3, wherein:
the display panel includes a through hole penetrating the display panel and located in a display area of the display panel; and
the first residue trace comprises an opening surrounding the through hole.

5. The display device of claim 4, wherein the second residue trace is in the opening, and surrounds the through hole, optionally wherein:
the opening is larger than the through hole in a plan view; and
the second residue trace is between the opening and the through hole.

6. The display device of any one of claims 1 to 5, wherein:
the display panel has a display area and a non-display area on one side of the display area; and
at least a part of the first residue trace is in the display area, and at least a part of the second residue trace is in the non-display area, optionally wherein a light transmittance of the first residue trace is higher than a light transmittance of the second residue trace.

7. The display device of any one of claims 1 to 6, wherein material compositions contained respectively in the first residue trace and the second residue trace are different from each other.

8. The display device of claim 7, wherein:
the first residue trace comprises at least one of acrylic resin, epoxy resin, or urethane resin; and
the second residue trace comprises at least one of acrylic resin, polyethylene resin, polyvinyl chloride resin, thiol resin, epoxy resin, or silicone resin, optionally wherein each of the first residue trace and the second residue trace comprises a same material as the at least one non-conductive film below the first residue trace and the second residue trace.

9. The display device of claim 7 or claim 8, wherein the second residue trace has higher acid resistance than that of the first residue trace, optionally wherein the second residue trace comprises a fluoropolymer, further optionally wherein the second residue trace comprises at least one of polytetrafluoroethylene (PTFE) or polyvinylidene fluoride.

10. The display device of any one of claims 1 to 9, wherein the display panel comprises:
a substrate;
a light emitting element layer on the substrate; and
an encapsulation layer on the light emitting element layer,
the first residue trace being on the encapsulation layer, and
the second residue trace being on the encapsulation layer and the substrate, optionally wherein:
the encapsulation layer exposes at least a part of a top surface of the substrate at an edge of the display panel, and
the second residue trace is on the exposed top surface of the substrate.

11. A method for manufacturing a display device, comprising:
forming a plurality of display cells on a mother substrate;
forming a coating layer on each of the plurality of display cells;
forming an acid resistant layer between the plurality of display cells;
forming a plurality of first laser irradiation areas by irradiating first laser to the mother substrate;
attaching a protective film onto the mother substrate; and
cutting the mother substrate along the plurality of first laser irradiation areas by spraying an etchant on the mother substrate without a mask.

12. The method of claim 11, wherein:
the coating layer is formed by an inkjet printing process; and
the acid resistant layer is formed by one of inkjet printing, dispenser printing, screen printing, or slit coating.

13. The method of claim 11 or claim 12, wherein material compositions in the coating layer and the acid resistant layer are different from each other.

14. The method of claim 13, wherein:
(i) the coating layer comprises at least one of acrylic resin, epoxy resin, or urethane resin, and
a residue trace comprises at least one of acrylic resin, polyethylene resin, polyvinyl chloride resin, thiol resin, epoxy resin, or silicone resin; and/or
(ii) the acid resistant layer has higher acid resistance than that of the coating layer, optionally wherein the acid resistant layer comprises a fluoropolymer, further optionally wherein the acid resistant layer comprises at least one of polytetrafluoroethylene (PTFE) or polyvinylidene fluoride.

15. The method of any one of claims 11 to 14, further comprising forming a plurality of second laser irradiation areas by irradiating second laser to the mother substrate,
wherein in the cutting of the mother substrate along the plurality of first laser irradiation areas, a through hole penetrating the plurality of display cells is formed along the plurality of second laser irradiation areas, optionally wherein:
the coating layer comprises an opening around the through hole,
the acid resistant layer is in the opening, and
the acid resistant layer fills the opening.
